(19) **Europäisches Patentamt / European Patent Office / Office européen des brevets**

(11) **EP 2 685 689 B1**

(12) **EUROPEAN PATENT SPECIFICATION**

(45) Date of publication and mention of the grant of the patent:
**01.04.2015 Bulletin 2015/14**

(21) Application number: **12005117.2**

(22) Date of filing: **11.07.2012**

(51) Int Cl.:
*H04L 27/26* (2006.01)  *H04L 27/34* (2006.01)
*H04L 27/36* (2006.01)  *H03C 5/00* (2006.01)
*H03F 1/32* (2006.01)  *H03F 3/24* (2006.01)

(54) **Technique for generating a radio frequency signal based on a peak compensation signal**

Technik zur Erzeugung eines Funkfrequenzsignals auf der Basis eines Spitzenkompensationssignals

Technique permettant de générer un signal de fréquence radio sur la base d'un signal de compensation de pic

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.01.2014 Bulletin 2014/03**

(73) Proprietor: **Telefonaktiebolaget L M Ericsson (PUBL)**
**164 83 Stockholm (SE)**

(72) Inventors:
• **Mu, Fenghao**
  **24563 Hjärup (SE)**
• **Sundström, Lars**
  **224 74 Lund (SE)**

(74) Representative: **Röthinger, Rainer**
**Wuesthoff & Wuesthoff**
**Patent- und Rechtsanwälte**
**Schweigerstrasse 2**
**81541 München (DE)**

(56) References cited:
**US-A1- 2002 122 467    US-A1- 2005 163 268**
**US-A1- 2010 067 617**

• **JINSEONG JEONG ET AL: "Wideband envelope tracking power amplifier with reduced bandwidth power supply waveform", MICROWAVE SYMPOSIUM DIGEST, 2009. MTT '09. IEEE MTT-S INTERNATIONAL, IEEE, PISCATAWAY, NJ, USA, 7 June 2009 (2009-06-07), pages 1381-1384, XP031490785, ISBN: 978-1-4244-2803-8**
• **MANJUNG SEO ET AL: "Performance Evaluation of a Windowed-Sinc Function-Based Peak Windowing Scheme for OFDM Polar Transmitters", IEICE TRANSACTIONS ON FUNDAMENTALS OF ELECTRONICS, COMMUNICATIONS AND COMPUTER SCIENCES, ENGINEERING SCIENCES SOCIETY, TOKYO, JP, vol. E94A, no. 7, 1 July 2011 (2011-07-01) , pages 1505-1512, XP001569202, ISSN: 0916-8508, DOI: 10.1587/TRANSFUN.E94.A.1505 [retrieved on 2011-07-01]**

EP 2 685 689 B1

**Description**

**Technical Field**

The present disclosure relates to a technique for generating a radio frequency signal. In particular, and without limitation, the disclosure relates to a transmitter chain of a mobile communication device and a method of operating such a transmitter chain.

**Background**

Modern mobile communication techniques, such as Long Term Evolution (LTE), require the linearity of the transmitter chain, particularly the linearity of a power amplification, over a wide dynamic range for transmitting signals having a high Peak to Average Power Ratio (PAPR). Transmitted signals include, e.g., Orthogonal Frequency-Division Multiplexed (OFDM) signals and Single-Carrier Frequency-Division Multiple Access (SC-FDMA) signals, which are known to have a high PAPR. However, the power efficiency of a power amplifier operated in its linear mode is low due to the large headroom that always has to be provided to prevent the clipping of rare power peaks.

Many methods of reducing the PAPR have been suggested including, e.g., SC-FDMA (which has an additional Fourier transformation stage in the transmitter chain when compared to OFDMA) and amplitude clipping. However, a radio frequency signal resulting from amplitude clipping is distorted, which distortion can be quantified in terms of an increased Error Vector Magnitude (EVM) or an increased Adjacent Channel Leakage power Ratio (ACLR). Thus, the decrease in power consumption is merely a trade-off against an increase of in-band modulation distortion and adjacent channel leakage. US 2002/0122467-A discloses a polar modulator wherein the phase component is modified in baseband to avoid zero crossings and restored after modulation.

**Summary**

Accordingly, there is a need for a technique that power-efficiently generates a radio frequency signal and fulfills specifications as to signal quality specified by radio standards.

According to one aspect, a method of generating a radio frequency signal based on a baseband signal is provided. The method comprises the steps of providing an amplitude signal and a phase signal depending on the baseband signal; modulating the phase signal to a carrier frequency and amplifying the modulated phase signal according to the amplitude signal to generate a preliminary radio frequency signal using a main modulating and amplifying unit; and feeding a peak compensation signal, which depends on the baseband signal, into the preliminary radio frequency signal to generate the radio frequency signal, the peak compensation signal being generated using an auxiliary modulating and amplifying unit and configured to at least essentially compensate for a saturation in the main modulating and amplifying unit, wherein the auxiliary modulating and amplifying unit is further used for feeding an offset compensation signal into the preliminary radio frequency signal, when the baseband signal is modified by adding an offset signal to reduce a bandwidth expansion in at least one of the phase signal and the amplitude signal, the offset compensation signal being derived from the offset signal.

In at least some embodiments, by compensating an influence of the baseband signal modification and by compensating the saturation, the radio frequency signal can achieve a high signal quality and be linear over a large dynamic range with improved power efficiency. By reusing the same auxiliary modulating and amplifying unit for feeding the offset compensation signal and for feeding the peak compensation signal, at least some embodiments realize a cost-efficient and compact transmitter.

At least one of the modulation and the amplification may be performed by operating a component in a non-linear mode or in a switched mode. The auxiliary modulating and amplifying unit may be different from the main modulating and amplifying unit. The auxiliary modulating and amplifying unit may include an auxiliary modulator and an auxiliary power amplifier. The auxiliary power amplifier may be a polar-modulated auxiliary power amplifier or a quadrature-modulated auxiliary power amplifier. Alternatively or in addition, the auxiliary modulating and amplifying unit may include a modulator with power driving ability. The main modulating and amplifying unit may include a main modulator and a main power amplifier. The main power amplifier may be supply-modulated. The amplitude signal may determine the supply modulation. The supply modulation may be determined so that the modulated phase signal is, at least in some signal regions, linearly amplified according to the amplitude signal. Alternatively or in addition, the main modulating and amplifying unit may include a modulator with power driving ability.

The baseband signal may be modified prior to the provision of at least one of the amplitude signal and the phase signal. The baseband signal may be modified by adding an offset signal. The offset signal may be configured to reduce the bandwidth expansion in a main power amplifier path including, or downstream of, the main modulating and amplifying unit. The offset compensation signal may at least essentially eliminate a distortion component, which corresponds to the offset signal, in the preliminary baseband signal.

The peak compensation signal may increase as the amplitude signal increases, if the baseband signal is in at least one of a first signal region and a second signal region, so that an amplitude of the radio frequency signal is a linear function of an amplitude of the baseband signal.

In the first signal region, an increase of output signal power of the radio frequency signal may be essentially due to the auxiliary modulating and amplifying unit. In the second signal region, an increase of output signal power of the radio frequency signal may be due to power combination from both the auxiliary modulating and amplifying unit and the main modulating and amplifying unit. The first signal region may be a peak amplitude region of the baseband signal. A clipping amplitude, $r_{max}$, may define at least one of a lower limit of the first signal region and an upper limit of a second signal region.

The method may further comprise the step of determining whether the baseband signal is in the first signal region or the second signal region, or predicting whether the baseband signal enters into the first signal region or the second signal region based on the baseband signal stored in a transmitter.

Feeding the peak compensation signal and feeding the offset compensation signal may occur in mutually exclusive signal regions of the baseband signal. The offset compensation signal may be fed into the preliminary radio frequency signal, only if the amplification is not saturated. The peak compensation signal may be fed into the preliminary radio frequency signal only in one or both of a first signal region and a second signal region. The offset compensation signal may be fed into the preliminary radio frequency signal only outside of one or both the first signal region and the second signal region. Alternatively, the step of feeding a peak compensation signal may be combined with the step of feeding the offset compensation signal in a third signal region.

The feeding of the peak compensation signal into the preliminary radio frequency signal further may include a calibrated combination of the peak compensation signal and the preliminary radio frequency signal. The calibrated combination may be performed, if the baseband signal is in the second signal region. The calibrated combination may be based on one or more weight coefficients. The method may further comprise the step of statically or dynamically calibrating one or all of the weight coefficients so that a signal amplitude provided by each of the auxiliary modulating and amplifying unit and the main modulating and amplifying unit is a smooth function of time.

The combined signals may be a linear function of the amplitude of the baseband signal. Each of the auxiliary modulating and amplifying unit and the main modulating and amplifying unit may be controlled in a smooth and/or continuous manner. Each of the auxiliary modulating and amplifying unit and the main modulating and amplifying unit does not have to generate a signal that is a linear function of the amplitude of the baseband signal. The control of each of the auxiliary modulating and amplifying unit and the main modulating and amplifying unit may be configured so that the combined signal is a linear function of the amplitude of the baseband signal.

The peak compensation signal may further be configured to modify the preliminary radio frequency signal so that the radio frequency signal approaches a first output signal region corresponding to the first signal region from a second output signal region corresponding to the second signal region with a transition time for the radio frequency signal that is longer than a transition time for the preliminary radio frequency signal. The transition time may provide for a smooth or soft transition. The transition time may be chosen so as to reduce spurious emission of the main modulating and amplifying unit.

The method may further comprise the step of determining or predicting whether the baseband signal is in a fourth signal region or enters into the fourth signal region. The method may further comprise, if the baseband signal is in the fourth signal region, the steps of modifying the baseband signal by adding an offset signal to the baseband signal, the offset signal being configured to prevent the modified baseband signal from entering a fifth signal region; and feeding an offset compensation signal derived from the offset signal into the preliminary radio frequency signal using the auxiliary modulating and amplifying unit, wherein the offset compensation signal is configured to at least essentially cancel a distortion component, which corresponds to the offset signal.

If the baseband signal is in the third signal region, at least essentially no offset signal is added. The third signal region may be adjacent to the fourth signal region. The third signal region may be outside the fourth signal region. The third signal region may surround the fourth signal region in constellation space. The second signal region may be adjacent to the third signal region. The second signal region may surround the third signal region in constellation space.

A saturation amplitude may define at least one of an upper limit of the third signal region and a lower limit of the second signal region. The third signal region may be defined by an amplitude of the baseband signal being between the activation amplitude and the saturation amplitude. The saturation amplitude may indicate a beginning of a saturation in the supply modulation response used in the amplification. The saturation amplitude may be a saturation amplitude of the supply-modulated power amplifier. The saturation amplitude may be defined as the amplitude of the baseband signal, at which the preliminary radio frequency signal at least essentially reaches a maximum output signal level that cannot be effectively increased by means of the supply modulation.

At least one of modifying the baseband signal, feeding the offset compensation signal into the radio frequency signal, and deriving the offset compensation signal from the offset signal may be performed, only if the baseband signal is in the fourth signal region. E.g., the step of modifying the baseband signal by the offset signal and feeding the offset compensation signal may be performed, only if the baseband signal is in the fourth signal region.

The fourth signal region may completely include the fifth signal region. The fifth signal region may be a subset of the fourth signal region. An activation amplitude may define an upper limit of the fourth signal region. A value of the activation amplitude may be adaptive to the maximum output power level. The minimum amplitude may be smaller than the activation amplitude.

The fifth signal region may be a prohibited signal region or an excluded signal region. The modified baseband signal may never enter the fifth signal region as a result of the added offset signal. The fifth signal region may be a vicinity of the origin in a plane spanned by the I component and the Q component, an area of a circle or ellipse centered at a constellation origin, or any other domain of the constellation plane of the baseband signal, wherein the domain includes a discontinuity of a baseband signal processing. A minimum amplitude may define an upper limit of the fifth signal region. The minimum amplitude may be determined by at least one of a maximum bandwidth of a phase signal path and maximum bandwidth of an amplitude signal path. Alternatively, the fifth signal region may be a rectangle including the origin.

At least one of the fourth signal region and the fifth signal region may change depending on an output signal level of the radio frequency signal and/or a modulation scheme applied for the baseband signal.

By modifying the baseband signal so that the modified baseband signal does not enter the fifth signal region, the provided phase signal and its subsequent processing does not necessarily suffer from a large bandwidth expansion. For example, the phase signal may change continuously or smoothly (e.g., avoiding sudden jumps for a time-continuous phase signal), or may change at increments of similar magnitude or at increments not exceeding a predefined maximum (e.g., for a time-discrete representation of the phase signal by means of a sequence of samples). By feeding the offset compensation signal, e.g. via an auxiliary power amplifier, into the preliminary radio frequency signal, the signal quality of the resulting radio frequency signal may be comparable to a linearly operated power amplifier.

The offset compensation signal and the peak compensation signal may be generated by the auxiliary power amplifier. The phase signal may be applied to the auxiliary power amplifier in at least one of the first signal region and the second signal region for peak compensation. Alternatively or in addition, a phase signal opposite to the offset signal may be applied to the auxiliary power amplifier in at least one of the fourth signal region and the fifth signal region for offset compensation.

The deriving of the peak compensation signal may include aligning the peak compensation signal relative to the preliminary radio frequency signal according to an alignment setting.

The peak compensation signal, the offset compensation signal or another compensation signal, which is generated by the auxiliary modulating and amplifying unit, may be configured to compensate a distortion in the preliminary radio frequency signal created by the main modulating and amplifying unit or by another component in a main power amplifier path. The main power amplifier path may include, or be arranged downstream of, the main modulating and amplifying unit. Any distortion created in the main power amplifier path may be corrected by applying a pre-distortion signal to an auxiliary power amplifier path. The auxiliary power amplifier path may be a signal path including the auxiliary modulating and amplifying unit. The pre-distortion in the auxiliary power amplifier path can obviate the need for a pre-distortion in the main amplifier path.

According to another aspect, a method of generating a radio frequency signal based on a baseband signal is provided. The method comprises the steps of modifying the baseband signal by adding an offset signal to the baseband signal, the offset signal being configured to prevent the modified baseband signal from entering a fifth signal region; providing an amplitude signal and a phase signal based on the modified baseband signal; modulating the phase signal to a carrier frequency and amplifying the modulated phase signal according to the amplitude signal to generate a preliminary radio frequency signal; and feeding an offset compensation signal derived from the offset signal into the preliminary radio frequency signal to generate the radio frequency signal, wherein the offset compensation signal is configured to at least essentially cancel a distortion component, which corresponds to the offset signal, in the preliminary radio frequency signal.

According to a still further aspect, a device for generating a radio frequency signal based on a baseband signal is provided. The device comprises a providing unit adapted to provide an amplitude signal and a phase signal depending on the base-band signal; a main modulating and amplifying unit adapted to modulate the phase signal to a carrier frequency and to amplify the modulated phase signal according to the amplitude signal to generate a preliminary radio frequency signal; and a feeding unit adapted to feed a peak compensation signal, which depends on the baseband signal, into the preliminary radio frequency signal to generate the radio frequency signal, wherein the feeding unit includes an auxiliary modulating and amplifying unit adapted to generate the peak compensation signal configured to at least essentially compensate for a saturation in the main modulating and amplifying unit, wherein the feeding unit is further adapted to feed an offset compensation signal generated by the auxiliary modulating and amplifying unit into the preliminary radio frequency signal, when the baseband signal is modified by adding an offset signal to reduce a bandwidth expansion in at least one of the phase signal and the amplitude signal, the offset compensation signal being derived from the offset signal.

The device may further include features described above in relation to any one of the method aspects, or may further include units adapted to perform one or more steps of such method aspects. E.g., the feeding unit may include an alignment unit. The alignment unit may include one or more of a delay unit, a phase rotation unit and a gain adjustment unit. A calibrating unit may be adapted to calibrate one or more of the delay unit, the phase rotation unit and the gain adjustment unit.

## Brief Description of the Drawings

In the following, the present disclosure is described in more detail with reference to exemplary embodiments illustrated in the drawings, in which:

Fig. 1     shows a baseband signal as a function of time in the plots (a) to (c) and in constellation space in the plot (d).

Fig. 2     shows four plots of a waveform of the baseband signal that causes a bandwidth expansion in a phase signal path;

Fig. 3     shows a schematic high-level block diagram of a device for generating a radio frequency signal based on a baseband signal according to the present invention;

Fig. 4     shows a flow diagram of a method of generating a radio frequency signal based on a baseband signal that can be performed by the device of Fig. 3;

Fig. 5     illustrates three trajectories of the baseband signal and a modified baseband signal in constellation space for small amplitudes;

Fig. 6     illustrates a construction of a vectorial factor defining a direction in constellation space for an offset signal;

Fig. 7     illustrates a plot of a complementary cumulative probability distribution of peak power;

Fig. 8     illustrates a trajectory of the baseband signal and the modified baseband signal in constellation space for large amplitudes;

Fig. 9     illustrates signal power levels of a preliminary radio frequency signal, a compensation signal, and a radio frequency signal for small and large amplitudes;

Fig. 10    shows a more detailed schematic block diagram of a first embodiment of the device of Fig. 3;

Fig. 11    shows a more detailed schematic block diagram of a second embodiment of the device of Fig. 3;

Fig. 12    shows a schematic block diagram of a switched polar-modulated auxiliary power amplifier that can be used in the first embodiment of Fig. 10; and

Fig. 13    shows a more detailed schematic block diagram of a variant of the first embodiment of the device of Fig. 11 for calibrating an alignment setting.

## Detailed Description

In the following description, for purposes of explanation and not limitation, specific details are set forth to provide a thorough understanding of the present disclosure. It will be apparent to those skilled in the art that the technique disclosed herein may be practiced in other embodiments that depart from these specific details. For example, while the following embodiments will primarily be described for OFDM signals or SC-FDMA signals as a baseband signal, the skilled artisan will appreciate that the present disclosure is not limited to an LTE implementation. Moreover, while the embodiments focus on a transmitter implementation in a mobile communication device, it will be apparent that the technique can also be implemented in a base station.

Those skilled in the art will further appreciate that the functions explained herein may be implemented using individual hardware components, using software functioning in conjunction with a programmed microprocessor or general purpose computer, using an Application Specific Integrated Circuit (ASIC), or using one or more Digital Signal Processes (DSPs). It will also be appreciated that the technique described herein could be embodied in a processor and a memory coupled to the processor, wherein the memory is encoded with one or more programs that perform the methods or method aspects disclosed herein when executed by the processor.

A pair of an in-phase component and a quadrature-phase component is also referred to as a quadrature-modulated signal. A pair of a phase signal with constant amplitude and an amplitude signal is also referred to as a polar-modulated signal.

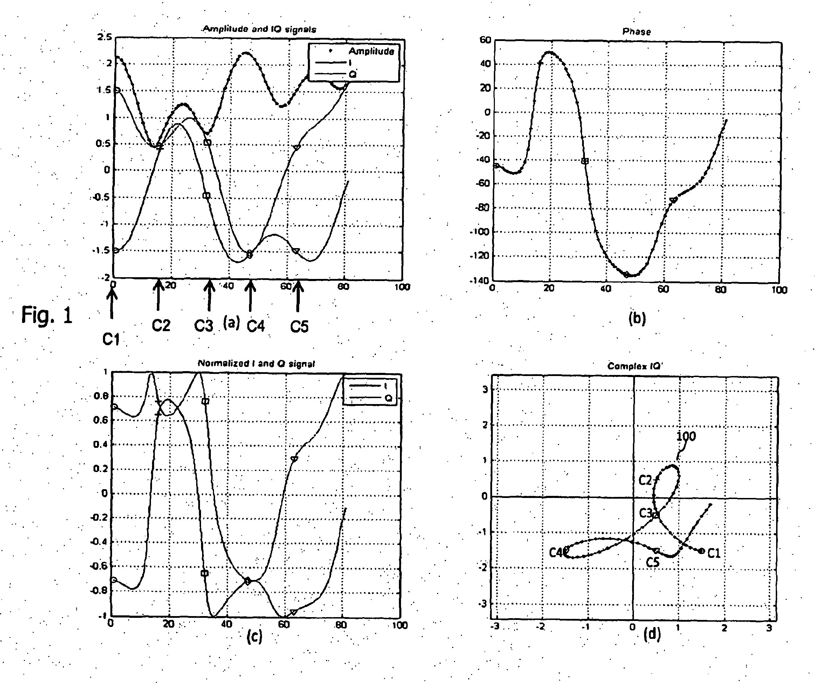

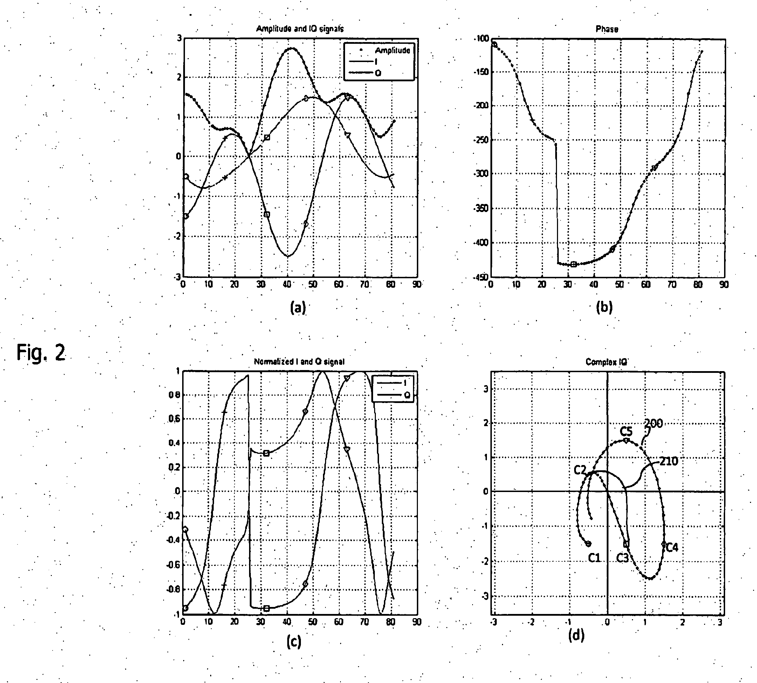

Each of the Figs. 1 and 2 shows a sequence of five symbols that are representative of a symbol sequence of OFDM signals or SC-FDMA signals used in an uplink channel of a mobile communication device according to Long Term Evolution (LTE). In terms of bandwidth expansion, Fig. 1 shows a "good" sample and Fig. 2 shows a "bad" sample. The five symbols are denoted by C1 to C5 and correspond to a sample of LTE SC-FDMA using 16QAM. Each of the Figs. 1(a) and 2(a) shows a diagram including the graphs of an I component, a Q component, and an amplitude signal r as a function of time t. Each of the Figs. 1(b) and 2(b) shows a graph of a phase signal φ as a function of time corresponding to the I and Q components shown in Figs. 1(a) and 1(b), respectively. Normalized graphs of the I and Q components are shown in the Figs. 1(c) and 2(c). The I and Q components define a quadrature-modulated baseband signal. The quadrature-modulated baseband signal, as represented by I(t) and Q(t), can be converted into a polar-modulated signal R(t) including the amplitude signal r(t) and the phase signal φ(t) according to

$$r(t) = \sqrt{I^2(t) + Q^2(t)}$$
$$\varphi(t) = \arctan\left(\frac{Q(t)}{I(t)}\right)$$
$$R(t) = r(t)e^{j\varphi(t)} \tag{1}$$

The Figs. 1(d) and 2(d) show a trajectory of the five symbols in the complex constellation plane according to $I(t) + j \cdot Q(t) = R(t)$. While the trajectory shown in Fig. 1(d) is located sufficiently away from the origin of the constellation plane corresponding to a continuous change in the phase signal φ(t) shown in Fig. 1(b), the trajectory shown in Fig. 2(d) essentially passes through the origin (i.e., comes very close to the origin compared to the extent of the trajectory in the constellation plane), which causes a sudden phase jump between the symbols C2 and C3. The phase jump essentially corresponds to 180°. Such a discontinuous behavior of the phase signal φ(t) causes a significant bandwidth expansion. The bandwidth expansion would be avoided, if the trajectory was pushed away from the origin, as is indicated by a segment 210 resulting by adding an offset sequence to the trajectory 200.

However, adding such an offset sequence reduces the signal quality of a radio frequency signal output by a transmitter in terms of an increased Error Vector Magnitude (EVM) and/or an increased Adjacent Channel Leakage Ratio (ACLR).

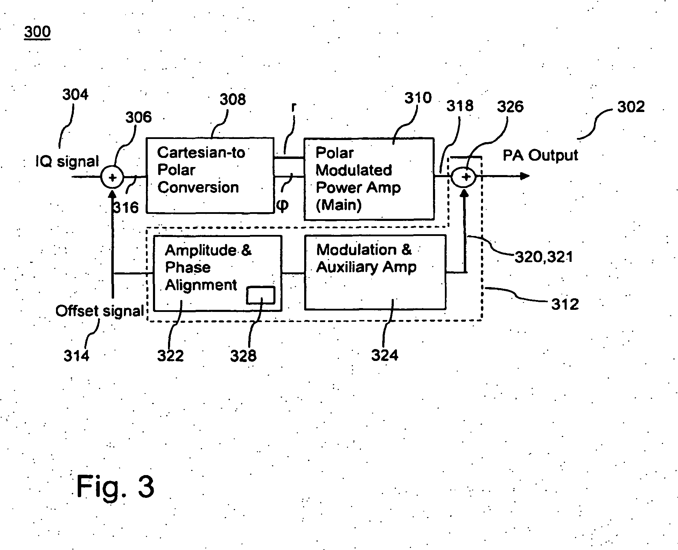

Fig. 3 shows a block diagram schematically illustrating a device 300 for generating a radio frequency signal 302 based on a baseband signal 304. The device 300 comprises a modifying unit 306, a providing unit 308, a main modulating and amplifying unit 310, and a feeding unit 312. The baseband signal 304 may be an IQ signal.

The modifying unit 306 is adapted to modify the baseband signal 304 by adding an offset signal 314 to the baseband signal 304 resulting in a modified baseband signal 316. The offset signal 314 is configured to prevent the modified baseband signal 316 from entering a fifth signal region. The providing unit 308 is adapted to provide an amplitude signal r and a phase signal φ converted from the modified baseband signal 316. The main modulating and amplifying unit 310 is adapted to modulate the phase signal φ to a carrier frequency $\omega_c$ and to amplify the modulated phase signal according to the amplitude signal r to generate a preliminary radio frequency signal 318.

The feeding unit 312 is adapted to feed an offset compensation signal 320 into the preliminary radio frequency signal 318 to generate the radio frequency signal 302. The offset compensation signal 320 is derived from the offset signal 314. The offset compensation signal 320 is configured to at least essentially cancel a distortion component, which corresponds to the offset signal 314, in the preliminary radio frequency signal 318. The modifying unit 306 is also referred to as a first adder 306.

At least one of the baseband signal 304, the offset signal 314, the modified baseband signal, the amplitude signal, the phase signal, and any other disclosed signal may be represented by a sequence of samples. At least one of the baseband signal 304, the offset signal 314, the modified baseband signal and the phase signal may be represented by a pair of an in-phase component (I component) and a quadrature-phase component (Q component). The phase signal may be represented by a pair of an I component and a Q component that have a constant amplitude, e.g., according to $I^2+Q^2=\text{constant}$. In other words, the phase signal may be represented by a rotating vector having a pair of orthogonal components I and Q. For a radio frequency phase signal, the vector rotates at the carrier frequency.

The feeding unit 312 includes an alignment unit 322, an auxiliary modulating and amplifying unit 324 and a second adder 326. The second adder 326 may be implemented by a coupler, a combination transformer, passive networks, or similar means. For example, the feeding may be performed directly in the voltage domain or in the current domain. The feeding in the current domain may include applying the preliminary radio frequency signal and the offset compensation signal to the same node. A maximum output power fed into the preliminary radio frequency signal may only be determined by a maximum magnitude of the offset signal. The maximum output power fed into the preliminary radio frequency signal may be 15-25 dB lower than a maximum output power of the preliminary radio frequency signal based on the baseband signal. As a relatively low maximum output power level is required from the auxiliary amplifier (being, e.g., 15-25 dB lower than the maximum output power of the main power amplifier), the feeding in the current domain can be linear and the distortions introduced by the offset signal can be compensated.

The alignment unit 322 and the auxiliary modulating and amplifying unit 324 are adapted for the step of deriving of the offset compensation signal 320 from the offset signal 314. The alignment unit 322 receives the offset signal 314. The alignment unit 322 aligns an amplitude of the offset signal 314 and a phase of the offset signal 314 according to an alignment setting 328 stored in the alignment unit 322. The offset compensation signal 320 is thus aligned according to the alignment setting 328 relative to the preliminary radio frequency signal 318. The alignment setting 328 is configured so that an amplitude of the offset compensation signal 320 is essentially equal to an amplitude of the distortion component and a phase of the offset compensation signal 320 is opposite to a phase of the distortion component.

The auxiliary modulating and amplifying unit 324 includes a quadrature-modulated power amplifier according to a first embodiment or a phase modulator in conjunction with a supply-modulated power amplifier according to a second embodiment. The offset compensation signal 320 thus is a modulated version of the offset signal 314.

By adding the offset signal 314 to the baseband signal 304, the corresponding symbol trajectory 200 is modified and pushed away from the constellation origin according to the segment 210 shown in Fig. 2. As a result, the modified baseband signal 316 does not exhibit the bandwidth expansion and the providing unit 308 provides the phase signal at a limited bandwidth. By feeding the offset compensation signal 320 into the preliminary radio frequency signal 318, an influence of the offset signal 314 on the spectrum and the EVM is removed from the radio frequency signal 302.

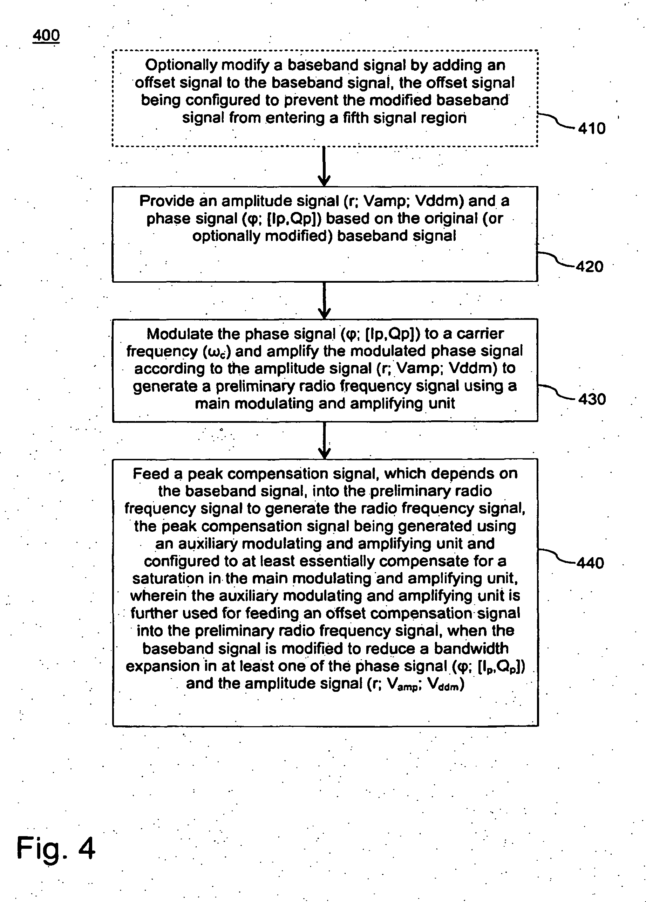

Fig. 4 shows a flow chart of a method 400 of generating a radio frequency signal based on a baseband signal. The method 400 may be performed by the device 300. The radio frequency signal may correspond to the radio frequency signal 302 and the baseband signal may correspond to the baseband signal 304 described above with reference to Fig. 3.

The method 400 comprises an optional step 410 of modifying the baseband signal, a step 420 of providing an amplitude signal r and a phase signal φ based on the original or, given the step 410, based on the modified baseband signal, a step 430 of modulating the phase signal φ to a carrier frequency $\omega_c$ and amplifying the modulated phase signal according to the amplitude signal r to generate a preliminary radio frequency signal 318, and a step 440 of feeding an offset compensation signal 320, if the modification step 410 was performed, or feeding a peak compensation signal 321 into the preliminary radio frequency signal 318. The peak compensation signal 321 is configured to compensate for a saturation of the main modulating and amplifying unit 310.

The offset signal 314 is configured to prevent the modified baseband signal 316 from entering a fifth signal region. The offset compensation signal 320 is derived from the offset signal 314. The offset compensation signal 320 is configured to at least essentially cancel a distortion component corresponding to the offset signal 314 in the preliminary radio frequency signal 318.

The steps 410, 420, 430 and 440 may be performed by the units 306, 308, 310 and 312, respectively. The method may further comprise, prior to the step 410, a step of predicting the signal amplitude. Latter step is possible, since the signal is known at the transmitter. The method may further comprise a step of assessing, based on the amplitude, whether the trajectory would enter the fifth signal region, or not.

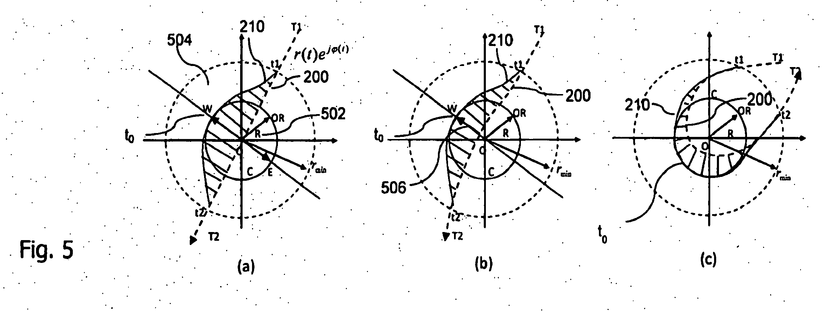

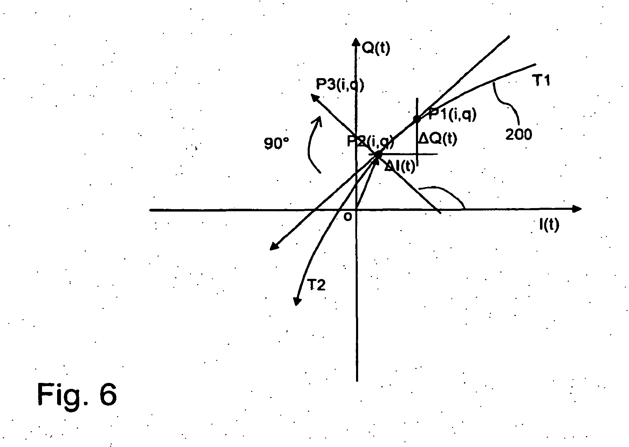

The step 410 of modifying the baseband signal 304 is illustrated in more detail in Figs. 5 and 6 in the constellation space spanned by the I and Q components, as introduced above with reference to Figs. 1(d) and 2(d). Using the complex-valued representation R(t) of the amplitude signal r(t) and the phase signal φ(t) defined by above set of equations (1), the polar-modulated signal R(t) is split in three different signal regions:

$$R(t) = r(t)e^{j\varphi(t)}$$
$$= \begin{cases} Ro(t)e^{j\theta(t)} - ro(t)e^{j\theta o(t)}, & r(t) < r_{min} \\ r(t)e^{j\varphi(t)}, & r_{min} \leq r(t) \leq r_{max} \\ r_{max}e^{j\varphi(t)} + [r(t) - r_{max}]e^{j\varphi(t)}, & r_{max} < r(t) \end{cases} \qquad (2)$$

wherein

$$Ro(t)e^{j\theta(t)} = r(t)e^{j\varphi(t)} + ro(t)e^{j\varphi o(t)}, \quad r(t) < r_{min}, \qquad (3)$$

is the modified baseband signal 316 represented as a polar-modulated signal and defined inside a circle of radius $r_{min}$ centered at the constellation origin. The offset signal 314 is represented as a polar-modulated signal by the second term on the right-hand side of equation (3). By inserting the offset signal 314 into the baseband signal 304, the polar components of the resulting modified baseband signal 316 according to equation (3) have a significantly reduced bandwidth compared to the polar components of the original baseband signal 304 according to equation (2).

The embodiment of the device 300 described above with reference to Fig. 3 performs the insertion of the offset signal 314 in "Cartesian coordinates", i.e., prior to converting the quadrature-modulated baseband signal 304 to a polar-modulated signal by means of the providing unit 308.

An exemplary generation of the offset signal 314, which is compatible with all device embodiments and method embodiments described herein, is illustrated with reference to the Figs. 5 and 6 using an implementation in polar coordinates. An offset sequence of the offset signal 314 is generated, wherein the amplitude ro(t) of the offset signal 314 is computed according to:

$$\varphi_o(t) = \varphi(t) \pm \frac{\pi}{2}, \qquad t1 < t < t2$$

$$ro(t) = Ao \cdot e^{\frac{-(t-t0)^2}{2\sigma_t^2}} = \max(R - r(t)) \cdot e^{\frac{-(t-t0)^2}{2\sigma_t^2}}, \qquad (4)$$

wherein Ao is a maximum amplitude of the offset signal 314 required to keep the modified baseband signal 316 according to equation (3) outside a fifth signal region 502 defined by a circle centered at the constellation origin with radius R, as is shown in Fig. 5. The circle with the radius $r_{min}$ defines a fourth signal region 504 that completely includes the fifth signal region 502.

In an alternative implementation using Cartesian coordinates, an in-phase component Io(t) and a quadrature-phase component Qo(t) are computed according to:

$$ro(t) = Ao \cdot e^{-\frac{(t-t0)^2}{2\sigma_t^2}}$$

$$Ao = \max(R - \sqrt{I^2(t) + Q^2(t)})$$

$$\varphi_o(t) = \arctan\left(\frac{Qo(t)}{Io(t)}\right) \approx \arctan\left(-\frac{\Delta I(t)}{\Delta Q(t)}\right)$$

$$Io(t) = ro(t)\sin(\varphi_o(t))$$

$$Qo(t) = ro(t)\cos(\varphi_o(t)) \qquad (4b)$$

The points labeled by time stamps t1 and t2 on the trajectory indicate where the trajectory 200 enters and leaves the fourth signal region 504, respectively, as is shown in Fig. 5. The maximum amplitude of the offset signal 314 occurs at a time t0, which is approximately at (t1+t2)/2. Fig. 5(a) shows the case of a trajectory of the baseband signal 304 that essentially passes over the constellation origin. In this case, the offset signal 314 can be inserted in two ways that force the trajectory of the modified baseband signal 316 to pass either point E or W on the circle C defining the boundary of the fifth signal region 502.

In the general case shown in Fig. 5(b), the original baseband signal 304 passes by the constellation origin but traverses through the fifth signal region 502. In this case, a vectorial factor 506 defining the direction of the offset signal 314 in constellation space is almost constant in time with a small direction variation. The side at which the original baseband signal 304 passes by the constellation origin thus defines the vectorial factor 506 of the offset signal 304. In one variant, the constant direction OW (i.e., the vector pointing from the constellation origin to the point W) is used for computing the offset sequence of the offset signal 314.

The computation of the vectorial factor 506 defining the direction of the offset signal 314 in constellation space is illustrated in Fig. 6. The original baseband signal 304 corresponds to a trajectory, a segment of which is shown from T1 to T2. The segment T1T2 includes sample points P1(i,q) and P2(i,q). To calculate the vectorial factor P2P3 of the offset signal 314 at the sample point P2, the vectorial difference between P1 and P2 is calculated in the plane spanned by the components I and Q. The vectorial difference $[\Delta I(t),\Delta Q(t)=[P1(i,q)-P2(i,q)]$ is a tangential direction of the trajectory segment at the sample point P2. The direction P2P3 defining the vectorial factor for the computation of the offset signal 314 at the point P2 is perpendicular to P1P2. It is noted that the vectorial factor can be computed, for example, by applying a matrix

$$\begin{bmatrix} 0, & -1 \\ 1, & 0 \end{bmatrix},$$

without deriving or processing the (potentially bandwidth-expanded) phase $\varphi$ of the baseband signal 304.

Above examples for generating the offset signal 314 also apply to the situation shown in Fig. 5(c), in which the trajectory 200 corresponding to the original baseband signal 304 forms a turn inside the fifth signal region 502 and is pushed outside of the fifth signal region 502 according to the segment 210.

While the operation of the device 300 according to the method 400 is described above with emphasis on the fifth signal region 502 and the fourth signal region 504 for small amplitudes, the same hardware, in particular the auxiliary modulating and amplifying unit 324 and the second adder 326 of the feeding unit 312, can be re-used for large amplitudes of the baseband signal 304. More specifically, large amplitudes refer to amplitudes of the baseband signal 304 that exceed a saturation amplitude $r_s$ of the main modulating and amplifying unit 310.

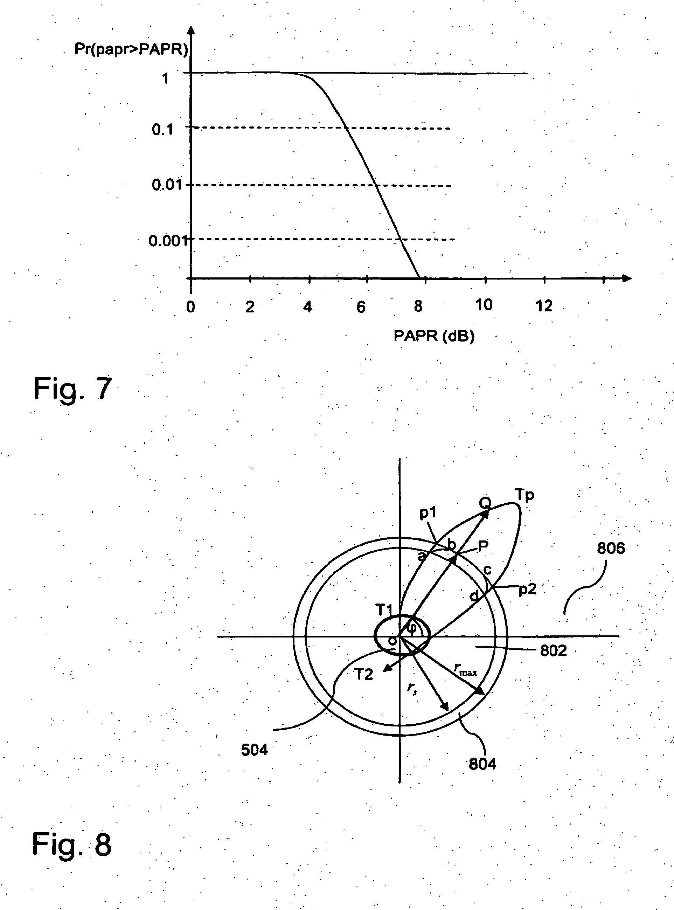

Fig. 7 shows a cumulative amplitude distribution plot of a typical complex-valued baseband signal 304 including OFDM or SC-FDMA symbols. The vertical logarithmic axis of the diagram shown in Fig. 7 represents the probability for a current peak to average power ratio (which is shown on the horizontal axis) being below the total peak to average power ratio of the baseband signal 304. The exponential decay of the probability indicates the rareness of such large peaks. Due to the limited output signal power level of the main modulating and amplifying unit 310, the radio frequency signal 302 may suffer from an amplitude clipping. For SC-FDMA or OFDM used in an uplink of a mobile device according to LTE, the amplitude clip causes a distortion of the radio frequency signal 302 increasing the EVM and the ACLR. In other words, the signal quality of a conventional transmitter chain is also degraded for large amplitudes, and it is suggested to re-use the same auxiliary modulating and amplifying unit 324 and the same second adder 326 in the large-amplitude regions, as is described below.

Amplitudes of the baseband signal larger than the activation amplitude $r_{min}$ (which defines the upper limit of the fourth signal region 504) and smaller than the saturation amplitude $r_s$ define a third signal region 802 shown in Fig. 8. The fourth signal region 504 is either dynamically or statically scaled to the signal power level of the output radio frequency signal 302. As the saturation amplitude $r_s$ is determined by a transfer function of the power amplifier 310, the saturation amplitude $r_s$ is normally a fixed parameter, while $r_{min}$ is a scalable parameter. For amplitudes above the activation amplitude $r_{min}$, i.e., outside the fourth signal region 504, no offset signal 314 is generated and the alignment unit 322 is deactivated. The auxiliary modulating and amplifying unit 324 is only deactivated in the third signal region 802.

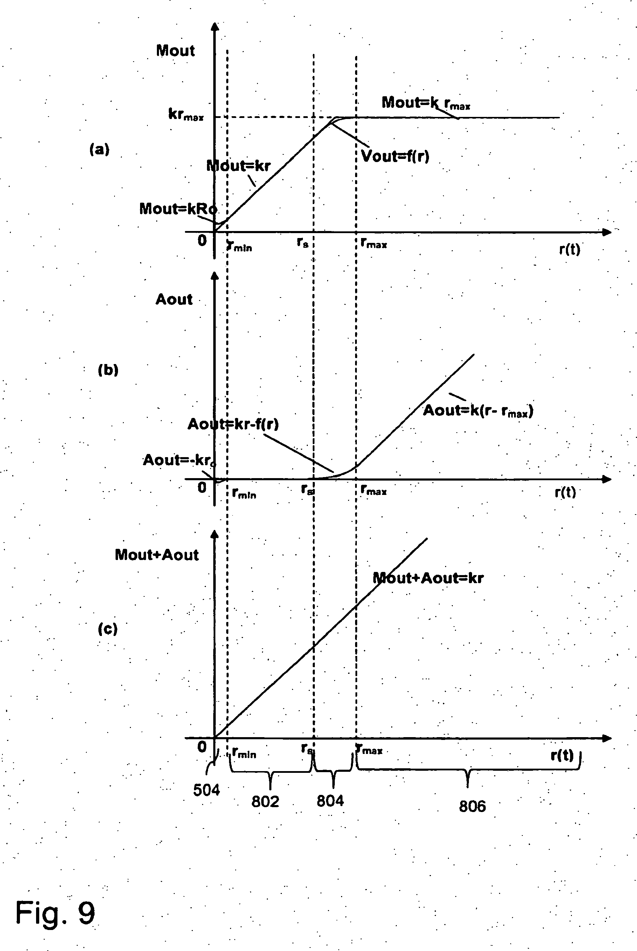

To enhance the output signal power level of the main modulating and amplifying unit 310, the auxiliary modulating and amplifying unit 324 is enabled or switched on, if the amplitude of the baseband signal 304 exceeds the saturation amplitude $r_s$. Fig. 9(a) illustrates the output signal amplitude, Mout, of the preliminary radio frequency signal 318 that is output by the main modulating and amplifying unit 310. Above a clipping amplitude $r_{max}$ of the baseband signal 304, the output signal amplitude Mout of the main modulating and amplifying unit 310 is essentially constant. The transition region for amplitudes larger than the saturation amplitude $r_s$ and smaller than the clipping amplitude $r_{max}$ is referred to as a second signal region 804, as is shown in each of the Figs. 8 and 9. Baseband signals 304 having an amplitude above the clipping amplitude $r_{max}$ are collectively referred to as a first signal region 806, which is also shown in the Figs. 8 and 9.

The auxiliary modulating and amplifying unit 324 thus provides a peak compensation signal 321 in the second signal region 804 and the first signal region 806. The phase signal may be applied to the auxiliary power amplifier in at least one of the second signal region 804 and the first signal region 806. The auxiliary power amplifier may be a polar-modulated auxiliary power amplifier or a quadrature-modulated auxiliary power amplifier. The auxiliary power amplifier may be operative in a linear mode, e.g., in the second signal region 804.

The compensation signal 320 or 321 may be aligned relative to at least one of the baseband signal 304 and the offset signal 314. The compensation signal 320 or 321 may be aligned according to an alignment setting. The alignment may include one or more of time delaying, phase rotating and gain adjusting the compensation signal. The alignment setting may be stored and/or updated.

Fig. 9(b) illustrates an output power of the peak compensation signal 321 in the second signal region 804 and in the first signal region 806. The peak compensation signal 321 is fed into the preliminary radio frequency signal 318 by means of the second adder 326. The additional output power Aout provided by the auxiliary modulating and amplifying unit 324 to the main modulating and amplifying unit 310 thus reduces the probability of amplitude clipping. Fig. 9(c) illustrates the output signal power of the radio frequency signal 302 downstream of the second adder 326. Denoting the gain of the main modulating and amplifying unit 310 (in the third signal region 802) by the symbol k, the combined output power of the radio frequency signal 302 from both the main modulating and amplifying unit 310 and the auxiliary modulating and amplifying unit 324 is a linear function of the amplitude signal r of the baseband signal 304 with the gain k maintained in the second signal region 804 and in the first signal region 806.

Fig. 9 also provides an overview including the fourth signal region 504 and the third signal region 802 described above with reference to the equations (2) to (4b). A negative value of Aout shown in Fig. 9(b) for the fourth signal region 504 corresponds to the offset compensation signal 320, which phase is aligned by means of the alignment unit 322 to counter the phase of the preliminary radio frequency signal 318, which output signal amplitude, Mout, is shown in Fig. 9(a).

The offset compensation signal 320 and the peak compensation signal 321 are collectively referred to as compensation signals 320, 321. It is emphasized that, while a polar-modulated notation is used in what follows for the compensation signals 320, 321, the auxiliary modulating and amplifying unit 324 providing the compensation signals 320, 321 can be implemented either in polar modulation or quadrature modulation domain.

The compensation signals 320, 321 are described with reference to the Figs. 5, 8 and 9 for a polar-modulated implementation of the main modulating and amplifying unit 310. The preliminary radio frequency signal 318 is optimized in the fifth signal region 502 and the fourth signal region 504 by feeding the offset compensation signal 320 into the preliminary radio frequency signal 318, and the maximum output level $k \cdot r_{max}$ is enhanced in the second signal region 804 and the first signal region 806 by feeding the peak compensation signal 321 into the preliminary radio frequency 318. The preliminary radio frequency signal that is output by the main modulating and amplifying unit 310 is denoted by the symbol Mout and expressed as:

$$Mout(t) = \mathrm{Re}\left[M(t)e^{-j[\omega t + \zeta(t) + o(t)]}\right]$$

$$M(t)e^{-j[\omega t + \zeta(t) + o(t)]} = \begin{cases} k \cdot Ro(t)e^{-j[\omega t + \theta(t) + o(t)]}, & r(t) < r_{min} \\ k \cdot r(t)e^{-j[\omega t + \varphi(t) + o(t)]}, & r_{min} < r(t) < r_s \\ f(r(t))e^{-j[\omega t + \varphi(t) + o(t)]}, & r_s < r(t) < r_{max} \\ k \cdot r_{max}e^{-j[\omega t + \varphi(t) + o(t)]}, & r_{max} < r(t) \end{cases}$$

and

$$\zeta(t) = \begin{cases} \theta(t), & r(t) < r_{min} \\ \varphi(t), & r(t) \geq r_{min} \end{cases} \tag{5}$$

Using a corresponding complex notation, the compensation signals 320, 321 that are output by the auxiliary modulating and amplifying unit 324 are denoted by the symbol Aout and expressed as:

$$Aout(t) = \mathrm{Re}\left[A(t)e^{-j[\omega t + \psi(t) + o(t)]}\right]$$

**and the modulation phase**

$$\psi(t) = \begin{cases} \varphi_o(t), & r(t) < r_{min} \\ \varphi(t), & r(t) \geq r_{min} \end{cases}$$

**and the modulation amplitude**

$$A(t) = \begin{cases} -k \cdot ro(t), & r(t) < r_{min} \\ o(t), & r_{min} < r(t) < r_s \\ [k \cdot r(t) - f(r(t))] & r_s < r(t) < r_{max} \\ k \cdot (r(t) - r_{max}), & r_{max} < r(t) \end{cases} \tag{6}$$

The contribution, o(t), of the auxiliary modulating and amplifying unit 324 can be set to zero, if the main modulating and amplifying unit 310 does not require any compensation in the third signal region 802.

The peak compensation in the second signal region 804 depends on a saturation characteristic Vout = f(r) of the modifying and amplifying unit 310. The saturating characteristic is approximated by a polynomial in r:

$$f(r(t)) = \beta_0 + \beta_1 r(t) + \beta_2 r(t)^2 + \beta_3 r(t)^3 + \beta_4 r(t)^4 + \dots , \qquad (7)$$

wherein the coefficients $\beta_0$, $\beta_1$, ... are stored in the feeding unit 312.

The phase $\sigma(t)$ in equations (5) and (6) is a phase delay from the input to the output of the main modulating and amplifying unit 310.

As can be gathered from the set of equations (6), a modulation phase $\psi$ equals the counter phase $\varphi_0$ in the fifth signal region 502 and the fourth signal region 504 to cancel the distortion component of the offset signal, while the modulation phase $\psi$ equals the phase signal $\varphi$ of the baseband signal 304 outside the fourth signal region 504.

The radio frequency signal 302 resulting from merging together the preliminary radio frequency signal 318 denoted by Mout and the compensation signals 320, 321 denoted by Aout thus is

$$Tx(t) = Mout(t) + Aout(t) = k \cdot r(t)\cos[\omega(t) + \varphi(t) + \sigma(t)] . \qquad (8)$$

Accordingly, the optimized and enhanced radio frequency signal 302 is linearly amplified in all five signal regions. Since the offset compensation signal 320 and the peak compensation signal 321 are generated and fed into the preliminary radio frequency signal 318 in mutually exclusive states of operation (namely the fifth signal region 502 and the fourth signal region 504 on the one hand, and the second signal region 804 and the first signal region 806 on the other hand) the same hardware can be re-used for generating and feeding the compensation signals 320, 321.

Feeding the peak compensation signal 321 into the generated preliminary radio frequency signal 318 may further include a weighted combination of the peak compensation signal 321 and the preliminary radio frequency signal 318. There are many ways to combine outputs by addition. In one example, each of the preliminary radio frequency signal 318 and the peak compensation signal 321 may obey a respective polynomial function (e.g., based on f(r) described above) of the amplitude, r, that increases between the saturation amplitude and the clipping amplitude. As an advantage, both of the outputs (i.e., the preliminary radio frequency signal 318 and the compensation signal) are continuous and/or smooth. The weighted combination may suppress unwanted distortions by a continuous or smooth combination as the amplitude of the baseband signal changes. E.g., the smooth combination may include continuous derivatives of first or second order with respect to the amplitude of the baseband signal.

The method 400 may further comprise a step of calibrating one or more weighting coefficients of the weighted combination. At least one of the one or more weighting coefficients may define a gain of the peak compensation signal that is fed into the preliminary radio frequency signal 318. The calibration may be static or dynamic. The one or more weighting coefficients may be calibrated so that the weighted combination provides a linear frequency translation of the baseband signal also at an upper limit of the third signal region and/or in the second signal region. The one or more weighting coefficients may further be calibrated so that out-off-band emissions are minimized.

The calibration guarantees that the radio frequency signal is linearly related to the baseband signal. As a result, the linearity can be maintained, even though a characteristic of at least one of the auxiliary modulating and amplifying unit and the main modulating and amplifying unit changes (e.g., due to changes in operating temperature).

The linear relation may include a gain, k, of the signal amplitude and/or a linear frequency translation according to the carrier frequency. For example, in the first signal region 806, the main power amplifier is saturated at a level $k \cdot r_{max}$ and the auxiliary power amplifier is calibrated to deliver a (residual) portion of a signal level $k \cdot (r - r_{max})$. In the second region 804, on the other hand, the auxiliary power amplifier is required to provide a (residual) portion of a signal level $k \cdot r - f(r)$. Here, f(r) can be any function that approximates an output transfer function of the main power amplifier. The function may be tabulated by means of the weight coefficients. For instance, the function f(r) may be a piece-wise linear function, a quadratic function, a cubic function, or, in general, a polynomial function of the amplitude signal r.

The combined radio frequency signal output should be a linear translation in frequency domain as a function of the baseband signal. Any non-linearity in the radio frequency signal resulting from the combination might introduce harmonic distortions, inter-modulation distortions, or lead to unwanted spurious emissions outside of a predefined spectral window.

There are many ways to calibrate the combination to reach a required level of linearity. The calibration can be performed in a static or dynamic manner. For instance, in the static calibration, a slope or a saw-tooth signal oscillating between the origin (i.e., zero amplitude) and a maximum amplitude substitutes the baseband signal during the calibration. The output amplitude is detected by a power detector and converted into a digital format by an analog-to-digital converter, ADC, and stored in a memory unit. According to the stored data, a pre-distortion look-up table, LUT, is created. Based on the LUT, the amplitude that is input to the auxiliary power amplifier path is pre-distorted so that a linear combination is reached.

In a reduced embodiment, the main power amplifier path has no pre-distortion. All distortions created by the main power amplifier may be corrected by the pre-distortion input to the auxiliary power amplifier path. As such, the auxiliary modulating and amplifying unit can be seen as a distortion compensating unit, wherein a dependency of the compensation signal is different for different signal regions. The different dependencies include, e.g., dependencies on either the baseband signal 304 or the offset signal 314, as well as different functional dependency.

Alternatively, the power detector used in the above-mentioned embodiment for the calibration is replaced by a tone detector or a frequency-selectable power detector. By way of example, the baseband signal is substituted by a two-tone test signal during the calibration. A non-linearity, if present in the combination, will produce many harmonic and inter-modulation tones. The combined radio frequency signal is down-converted into a baseband frequency domain or an intermediate frequency domain. The tone detector or the frequency-selectable power detector is employed to detect the non-linearity of the combination.

The static calibration can provide a stable and robust solution for linear combination, but requires a stable test signal. The static calibration is preferably performed at manufacture and not during normal operation.

In the dynamic calibration, there is no stable test signal, so the real baseband signal is used instead. Nevertheless, the non-linearity still creates harmonic and inter-modulation distortions, i.e., the spurious emissions in out-of-band location of the spectrum. Detecting the spurious emissions at out-of-band frequencies, and minimizing them by modifying the pre-distortion table, LUT, the linearity of the combination is optimized.

The method 400 may further comprise a case differentiation depending on the amplitude signal r. In case the amplitude signal r is smaller than the activation amplitude $r_{min}$, the steps 410, 420, 430 and 440 are performed as described above. In case the amplitude signal r of the baseband signal 304 is greater than the saturation amplitude $r_s$, the method may further comprise the steps of providing the amplitude signal r and the phase signal φ depending on the baseband signal 304, modulating the phase signal φ to the carrier frequency $\omega_c$, amplifying the modulating phase signal according to the amplitude signal r to generate the preliminary radio frequency signal 318, and feeding the peak compensation signal 321, which depends on the baseband signal 304, into the preliminary radio frequency signal 318, wherein the peak compensation signal 321 is configured to at least essentially compensate for a saturation in the amplification step.

The case differentiation is described in more detail below.

First Signal Region:

The first signal region 806 corresponds to a peak region in the baseband signal 304 when its amplitude signal is $r(t) > r_{max}$. The trajectory 200 enters a peak segment p1-Tp-p2 shown in Fig. 8. The main modulating and amplifying unit 310 has a saturated power level and the auxiliary modulating and amplifying unit 324 provides an additional linear output to enhance the total power level of the radio frequency signal 302. Both of the units 310 and 324 contribute to the output power. As the units 310 and 324 apply power to the output side of each other, the power efficiency drops in the first signal region 806. To the benefit of the overall power efficiency, the probability for operating in the first signal region 806 is extremely low according to the exponentially suppressed probability shown in Fig. 7. Consequently, the contribution of the first signal region 806 to the overall power efficiency of the device 300 and the method 400 is almost negligible.

Second Signal Region:

When the amplified signal fulfills $r_s \leq r(t) \leq r_{max}$, the trajectory 200 is far away from the constellation origin but close to the saturated power level of the main modulating and amplifying unit 310. A hard amplitude clipping occurs in the main modulating and amplifying unit 310, if the amplitude signal further increases to the clipping amplitude $r_{max}$. In the second signal region 804, the main modulating and amplifying unit 310 operates to its maximum output signal power level and the auxiliary modulating and amplifying unit 324 operates at a fraction of its maximum output signal power capability providing a relatively weak power Aout as the peak compensation signal 321 determined by k·r(t)-f(r(t)), which is shown in Fig. 9(b). The peak compensation signal 321 compensates for the beginning saturation of the main modulating and amplifying unit 310, so that the radio frequency signal 302 is linearized. Since the operation in the second signal region 804 only occurs when the required transmission power level is very large and close to the saturated power level $kr_{max}$, the probability for operating in the second signal region 804 is very low.

Third Signal Region:

The third signal region 802 is a region of linear operation of the main modulating and amplifying unit 310 and defined by the amplitude signal fulfilling $r_{min} \leq r(t) \leq r_s$. The trajectory 200 is outside both the fourth signal region 504 and the second signal region 804, so that there is neither bandwidth expansion nor amplitude clipping. In the third signal region 802, only the main modulating and amplifying unit 310 operates, which is optimized to have good power efficiency in the third signal region 802. In case the main modulating and amplifying unit 310 requires any compensation or does not meet the requirements as to signal quality for the radio standard that is adopted, the above-mentioned compensation signal, o(t), which is output by the auxiliary modulating and amplifying unit 324, compensates for imperfections introduced by the main modulating and amplifying unit 310. The saturation amplitude $r_s$ defining the upper limit of the third signal region 802 is a pre-defined value that determines when the auxiliary modulating and amplifying unit 324 is to be powered-on to provide the enhancing output signal power of the peak compensation signal 321. The probability for operating in the third signal region 802 is very high. Consequently, the power efficiency of the device 300 and the method 400 is mainly determined by the good power efficiency in the third signal region 802.

Fourth and Fifth Signal regions:

When the amplitude signal fulfills r(t) < $r_{min,}$ the trajectory 200 potentially also enters the neighborhood of the origin, i.e., the fifth signal region 502, in which the bandwidth expansion occurs. The offset signal 314 is inserted as an offset sequence including offset samples, each of which is computed according to the equations (3) and (4) or (4b) to reduce the bandwidth expansion introduced by the Cartesian to polar coordinate conversion performed by the providing unit 308. This reduces the bandwidth requirements of both an amplitude signal path and a phase signal path, and makes polar modulation possible even for wideband applications such as LTE. After polar modulation, i.e., downstream to the main modulating and amplifying unit 310, the distortion component corresponding to the inserted offset signal 314 is removed from the preliminary radio frequency signal 318 by adding a negative modulating signal $ro(t) \cdot e^{j8o}(t)$ that is created by the auxiliary modulating and amplifying unit 324. Consequently, both units 310 and 324 operate in the fourth signal region 504. The overall time average probability for operating in this state is fairly low. In more advanced embodiments of the device 300 and the method 400, the activation amplitude $r_{min}$ changes according to different transmission power levels and different modulation methods, e.g., QPSK, 16QAM, etc.

In order to avoid a quick or sharp clip, the peak compensation signal 321 may further be configured to modify the preliminary radio frequency signal 318 (i.e., the output of the amplification) to approach the maximum output signal level of the preliminary radio frequency signal (i.e., the output level corresponding to the lower limit of the first signal region 806) with a predefined transition time or a finite time constant.

The benefit of the transition in the second signal region 804 can be understood from Fig. 8. While the signal regions shown in Fig. 8 relate to the baseband signal 304 (e.g., as applied at the input of the main modulating and amplifying unit 310 or the providing unit 308), corresponding signal regions exits for the preliminary radio frequency signal 318 (i.e., at the output of the main modulating and amplifying unit 310) and are denoted by first output signal region to fifth output signal region, respectively.

According to equations (5) and (6), when the amplitude of the baseband signal 304 is larger than the baseband signal 304 is split into two signals. For example, the instantaneous baseband signal OQ at trajectory (T1-Tp-T2), which is shown in Fig. 8, can be split into OP and PQ both with the same phase φ. If the transition region does not exist, the trajectory T1-a-p1-Tp-p2-d-T2 is decomposed into T1-a-p1-p2-d-T2 for the main modulating and amplifying unit 310 and p1-Tp-p2 for the auxiliary modulating and amplifying unit 324, respectively. Consequently, a change of directions in a-p1-p2-d is too sharp and requires too wide bandwidth for cost-effective implementations.

With the transition defined in the fourth region 804, $r_s \leq r(t) \leq r_{max}$, the trajectory T1-a-p1-Tp-p2-d-T2 is decomposed into T1-a-b-c-d-T2 for the main modulating and amplifying unit and a-p1-Tp-p2-d for the auxiliary modulating and amplifying unit 324, respectively, thus making the transition smoother. So the transition time from the second signal region 804 to the first signal region 806 is extended, i.e., the time from a-p1 is extended to a-b. The smooth transition implies more relaxed bandwidth requirements for implementations and lower distortions created in both amplitude and phase paths. The boundary between the second signal region 804 and the third signal 802 region can be adapted, either statically or dynamically, in order to further relax bandwidth requirements.

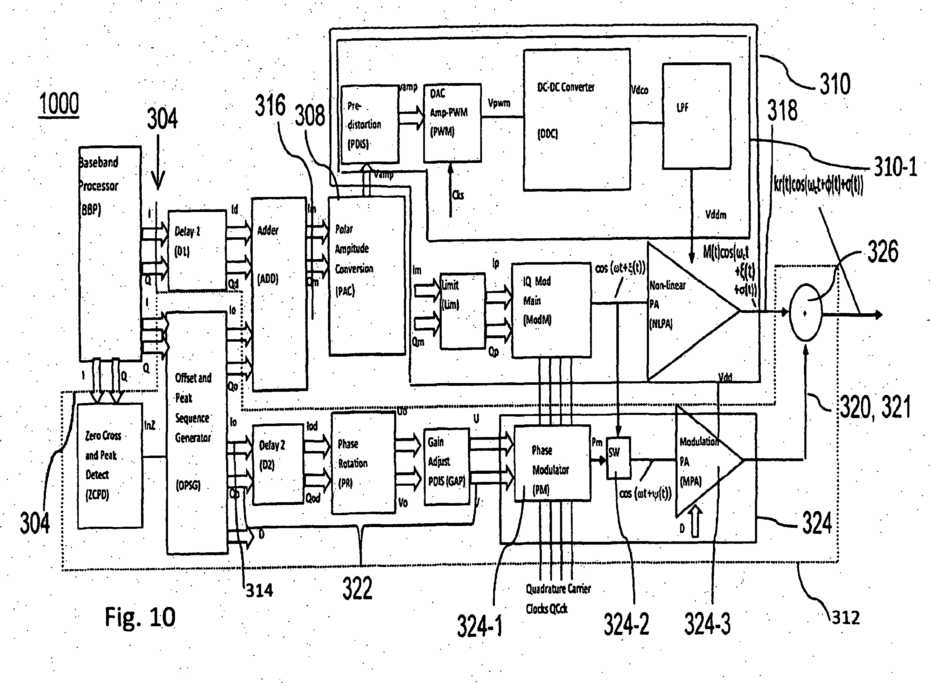

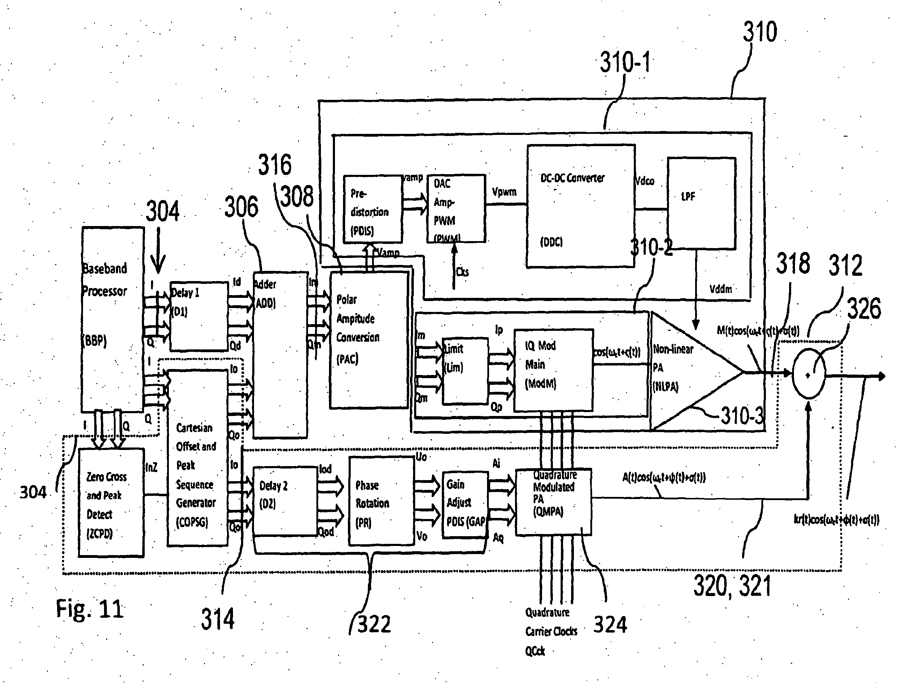

The Figs. 10 and 11 show more detailed block diagrams that schematically illustrate a first embodiment 1000 and a second embodiment 1100, respectively, of the device 300 for generating the radio frequency signal 302 based on the baseband signal 304 described above. Like reference signs denote implementations of units described above with reference to Fig. 3, a repetitive description of which is avoided here.

In both embodiments 1000 and 1100, the main modulating and amplifying unit 310 includes an amplitude signal path 310-1, a phase signal path 310-2 and a supply-modulated power amplifier 310-3 operative in a power-efficient non-linear mode. The power efficiency may correspond to a class E or F power amplifier operation. The amplitude M of the preliminary radio frequency signal 318 is a function of the supply voltage Vddm of the supply modulation. Optionally, a phase compensation cancels phase errors during amplitude modulation.

The amplitude signal path 310-1 includes a pre-distortion unit (PDIS), a digital-to-analog conversion unit (DAC), and a pulse width modulation unit (PWM), through which the amplitude signal of the baseband signal 304 is converted into a pulse sequence Vpwm. The pulse sequence Vpwm has a duty cycle that is a function of the baseband amplitude signal Vamp. The pulse sequence Vpwm controls a DC-DC converter (DDC) and creates an output voltage Vdco. A DC component in the voltage Vdco is proportional to the voltage Vamp. A low pass filter (LPF) removes all unwanted high-frequency components in the voltage signal Vdco in order to reduce out-off band emissions and spurious emissions, which are harmful for adjacent channels and for the receiver inside a mobile device including the device 300, respectively. The effect of the amplitude signal path 310-1 is the provision of a supply voltage Vddm configured to modulate the power amplifier 310-3 so that the amplitude M of the preliminary radio frequency signal 318 is proportional to the amplitude Vamp =|I(t)+jQ(t)| of the I and Q components provided by the providing unit 308 to the unit 310. The components in the amplitude signal path 310-1 are optimized for reaching high power efficiency.

In the phase signal path 310-2 of the unit 310, a limiter is employed to create a quadrature-modulated phase signal with components Ip and Qp received by an IQ modulation main unit (ModM). The limiter can be implemented in either an analog or digital manner. In a digital limiter, the components Ip and Qp of the normalized quadrature-modulated phase signal are created by

$$Ip(t) = \frac{\mathrm{Im}(t)}{\sqrt{\mathrm{Im}(t)^2 + Qm(t)^2}}$$

$$Qp(t) = \frac{Qm(t)}{\sqrt{\mathrm{Im}(t)^2 + Qm(t)^2}} \tag{9}$$

Thus, the amplitude of the phase signal $(Ip + j \cdot Qp)$ represented by the pair of Ip and Qp components is normalized to one.

In IQ modulation Main (ModM), the phase signal is modulated to the carrier frequency, $\omega_c = 2nfc$, creating the voltage Vp of the modulated phase signal:

$$Vp(t) = Ip(t)\cos(\omega_c t) - Qp(t)\sin(\omega_c t)$$

$$= \cos(\omega_c t + \xi(t))$$

$$\xi(t) = \arctan\left(\frac{Qp(t)}{Ip(t)}\right) \tag{10}$$

In the power amplifier 310-3, the modulated phase signal provided by the phase signal path 310-2 is amplified to the amplitude M proportional to Vamp, which in turn determines Vddm.

In both embodiments 1000 and 1100, a zero cross and peak detector (ZCPD) performs the above-described case differentiation by detecting data segments in the baseband signal 304 according to the amplitude signal r of the components I and Q.

When the amplitude signal r is very close to the fifth signal region 502, in which bandwidth expansion would occur for polar-modulated signals, the Offset and Peak Sequence Generator (OPSG) creates an offset sequence, which is added to the original I and Q signals via the first adder 306 and forces the modified signals Im and Qm away from the fifth signal region 502. OPSG also creates an amplitude signal D=D(1:n), which is a digital vector. The modified signals Im and Qm are converted to the modified baseband amplitude signal Vamp, from Cartesian coordinates to polar coordinates, i.e., $V_{amp} = \sqrt{I_m^2 + Q_m^2}$, by means of a Polar Amplitude Conversion (PAC) implementing the providing unit 308.

When the amplitude of the baseband signal 304 has a peak amplitude exceeding the saturation amplitude $r_s$, the ZCPD will detect the first or second signal regions 804, 806 and signal the OPSG to split the input signal into two parts: one for the power amplifier 310-3 and one for the feeding unit 312.

In both embodiments 1000 and 1100, the alignment unit 322 includes a delay unit (D2), a phase rotation unit (PR), and a gain adjustment unit (GAP). In the case of the second or first signal region 804, 806, the OPSG creates an amplitude control vector A, which controls the gain of the auxiliary modulating and amplifying unit 324 by means of the gain adjustment unit (GAP).

In the embodiment 1000, the auxiliary modulating and amplifying unit 324 includes a phase modulator 324-1, a switch 324-2 and a modulation power amplifier 324-3. The digital vector D of the OPSG is provided to the modulation power amplifier 324-3, which may also be referred to as an auxiliary power amplifier.

The modulation power amplifier 324-3 can be implemented in either digital or analog manner. For instance, a Gilbert mixer/modulator can be used in an analog implementation. For peak compensation, a radio frequency amplifier is normally required to amplify the signal power.

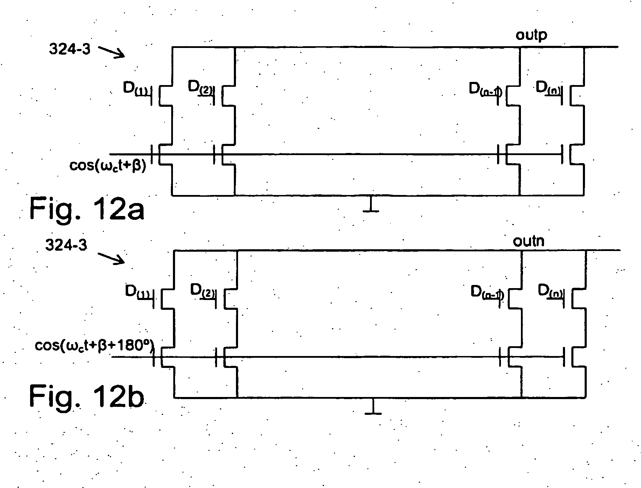

A digital quadrature-modulated differential power amplifier may be used in the embodiment 1000 built with a pair of differential quadrature modulators. One of the differential quadrature modulators is shown in the Figs. 12a and 12b, for positive and negative parts, respectively.

In the positive part, one of a quadrature radio carrier frequency signal or Local Oscillator (LO) clock signal, $\cos(\omega_c t+\beta)$, is connected to the gates of bottom transistors in n transistor branches, as is shown in Fig. 12a. The gates of the top transistors are connected to a digital amplitude control vector signal, D(1,2,...,n), in a weighted manner, such as a binary code or by other means. A branch can be enabled only when the corresponding control bit is set to logic high, otherwise it is disabled. Thus, the output of the power amplifier is proportional to the weighted factor determined by the amplitude control vector signal D.

In a similar way, the negative part uses the corresponding quadrature LO signal $\cos(\omega_c+\beta+180°)$, as is shown in Fig. 12b, to yield a "negative" output (denoted by "outn" in Fig. 12b).

For a quadrature-modulated differential power implementation, the pair of differential quadrature modulators preferably uses a pair of control vectors, D=[Di,Dq]; and quadrature LO clocks to create output. The two differential quadrature modulators are connected to Di and Dq, respectively. The two differential quadrature modulators are driven by quadrature clocks $\pm\sin(\omega_c t+\beta)$ and $\pm\cos(\omega_c t+\beta)$, respectively. The outputs of the two differential quadrature modulators are connected together. As a result, the preliminary radio frequency signal 318 is created based on a quadrature-weighted current sum.

When the auxiliary power amplifier is used for both the offset compensation and the peak compensation, the clock phases depend on the amplitude signal. The clock phases thus differ for offset compensation and peak compensation.

For peak compensation the phase of the auxiliary power amplifier and the main power amplifier may be ideally the same. An advanced implementation accounts for a slight delay difference or phase skew between the main power amplifier and the auxiliary power amplifier, e.g., depending on the types and/or the number of stages of the power amplifiers. A tunable delay unit is employed in the advanced implementation to compensate the delay difference. In all implementations, phases of the clocks used for the main power amplifier and auxiliary power amplifier can be taken from one source for the peak compensation.

For the offset compensation, the phase signal of the auxiliary power amplifier may be approximately perpendicular to the phase signal of the main power amplifier, according to Fig. 6 and Eq. (4b). As a consequence, the clock signal for the auxiliary power amplifier may also be derived from a single source, including a pi/2-phase shift for the auxiliary power amplifier. In such a case, a switch may be introduced to create an output clock by swapping between in-phase and quadrature-phase so that the clock signals used in the auxiliary power amplifier are toggled between offset compensation and peak compensation.

The embodiment 1100 uses a quadrature modulated power amplifier as the auxiliary modulating and amplifying unit 324. The embodiment 1100 further differs from the embodiment 1000 in that the OPSG is replaced by a Cartesian Offset and Peak Sequence Generator (COPSG), in which both offset sequence signals and peak enhancement signals are generated only in Cartesian coordinates.

Accordingly, the quadrature modulated power amplifier 324 used in the embodiment 1100 provides the compensation signal 320 or 321 according to:

$$A(t)e^{-j[\omega t+\psi(t)+\sigma(t)]} = k\left[A_i(t)+j\cdot A_q(t)\right]e^{-j[\omega t+\sigma(t)]} = \left[A(t)\cos(\psi(t))+j\cdot A(t)\sin(\psi(t))\right]e^{-j[\omega t+\sigma(t)]}$$

$$\left[A_i(t)+j\cdot A_q(t)\right]=\begin{cases} -\left[Io(t)+jQo(t)\right], & |I(t)+jQ(t)| < r_{min} \\ o(t), & r_{min} < |I(t)+jQ(t)| < r_s \\ I(t)+jQ(t)-f(I(t)+jQ(t)), & r_s < |I(t)+jQ(t)| < r_{max} \\ I(t)-r_{max}\cos(\varphi(t))+jQ(t)-j\cdot r_{max}\sin(\varphi(t)), & r_{max} < |I(t)+jQ(t)| \end{cases}$$

where

$$\varphi(t) = \arctan(\frac{Q(t)}{I(t)}) \cdot \qquad\qquad (11)$$

It is to be emphasized that the embodiments 1000 and 1100 are combinable. For example, the power amplifier 310-3 of the main modulating and amplifying unit 310 is implemented in a combined embodiment by means of the modified polar modulation (as described for the embodiments 1000 and 1100), and the auxiliary modulating and amplifying unit 324 includes a mixed-mode modulator, in which both the polar modulation and the quadrature modulation are implemented. The polar modulation and the quadrature modulation are employed for the fourth and fifth signal regions and for the first and second signal regions, respectively, or the other way around.

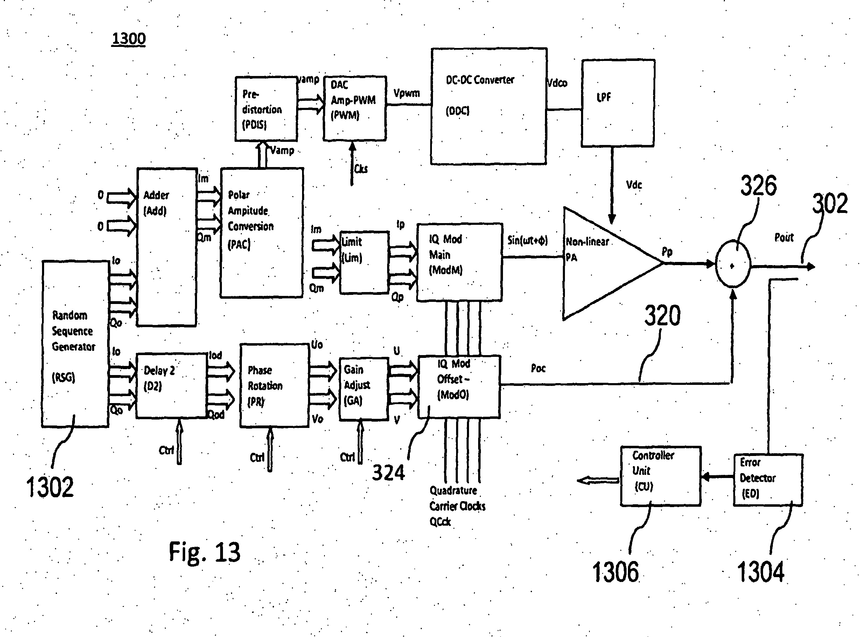

Fig. 13 shows an advanced variation 1300 of the embodiment 1100 that can be used for a calibration of the alignment setting 328 in the alignment unit 322. A random sequence generator 1302 generates a test signal, a pulse sequence with known repeating pattern or a pseudo random sequence with components Io and Qo replacing the narrowband offset sequence of the offset signal 314. One of the inputs of the first adder (which is used as the modifying unit 306) is set to zero. An error detector unit 1304 is configured to couple to the radio frequency signal 302 resulting from both the main modulating and amplifying unit 310 and the auxiliary modulating and amplifying unit 324. A controller unit 1306 provides a binary control vector as the alignment setting 328. Each of the components of the binary control vector controls a respective one of the delay unit D2, the phase rotation unit PR and the gain adjustment unit GA of the alignment unit 352. The control unit 1306 is configured to provide the binary control vector so as to minimize the output power received via the error detector unit 1304. The signal amplitude of the pseudo random sequence must be so weak such that the spurious emission due to its wide spectrum will not exceed the spectral mask required by different radio standards.

This calibration can be carried out "statically", i.e., before the transmitter operates. Alternatively or in addition, the calibration can be carried out "dynamically", i.e., during the transmission when the baseband signal is not in the fourth or fifth signal regions (when there is no need for an offset sequence performing offset cancellation).

For the calibration before transmission, a weak test signal is generated by the random sequence generator 1302 and fed into the main modulating and amplifying unit 310 and the auxiliary modulating and amplifying unit 324. The contributions output from the main modulating and amplifying unit 310 and the auxiliary modulating and amplifying unit 324 should cancel each other in the second adder 326, if the calibration of the alignment setting 328 is perfect. In practice, when calibration is not perfect, there will be a residual error in the output radio frequency signal 302 detected by the error detector unit 1304. The error detector unit 1304 reports an error amplitude to the controller unit 1306, based on which the controller unit 1306 provides the binary control vector so as to reduce the residual error until it meets predefined requirements.

For the calibration during transmission, the weak test signal can be modulated at an intermediate frequency that is higher than a frequency difference of duplexing in an adopted Frequency-Division Duplexing (FDD) standard, so the calibration signal will not overlap with the receiver band and degrade the receiver sensitivity.

The error detector unit 1304 can be implemented in different ways. In one variant; the error detector unit 1304 includes a correlation detector, which provides a maximum gain (and thus a maximum error amplitude) for the pulse sequence with known repeating pattern or for the pseudo random sequence, whereas the correlation detector is essentially insensitive to the radio frequency signal 302 to be transmitted.

As has become apparent, a requirement of high linearity in a transmitter chain can be combined with requirements as to high power efficiency using at least some of the above-described embodiments. Even if there was some non-linear interaction between the main modulating and amplifying unit 310 and the auxiliary modulating and amplifying unit 324 due to their coupled outputs via the second adder 326, the benefit for both offset compensation and peak compensation can be substantial. If, for example, the offset sequence 314 that is introduced results in an EVM of 10% in the preliminary radio frequency signal 318 and the level of cancellation is, e.g., 80%, the EVM after cancellation remaining in the radio frequency signal 302 is only 2%. In practice, aligning a delay mismatch between the main modulating and amplifying unit 310 and the auxiliary modulating and amplifying unit 324 and adjusting the gain in the alignment unit 322 is relatively easy. While maintaining the phase alignment in the alignment setting 328 may be more demanding, the above numerical example illustrates that the cancellation is substantial, even if it is not perfect. Assuming, e.g., 80% cancellation with the remaining part originating from an incorrect phase setting in the alignment setting 328, a phase error up to 6 degrees can be acceptable.

The bandwidth expansion problem in polar modulation has been solved in at least some of the embodiments by adding an offset sequence before a transformation from quadrature modulation to polar modulation, which avoids sharp changes in both amplitude and phase paths. The distortion reducing signal quality in terms of EVM or ACLR caused by the introduced offset sequence is removed by combining the preliminary radio frequency signal with a negative offset compensation signal.

While the power efficiency of polar modulation could not be harnessed in a conventional transmitter design for wideband LTE, at least some of above embodiments can be used for wideband LTE application with a bandwidth up to 20 MHz. As a result, the power efficiency of an up-link connection for a mobile device can be improved.

The auxiliary modulating and amplifying unit and the corresponding second adder are re-used for both offset cancellation and peak enhancement, because former and latter never happen at the same time, so that the hardware design is compact and cost-efficient.

In general, all kinds of imperfections introduced by the main modulating and amplifying unit can be reduced or eliminated by the auxiliary modulating and amplifying unit.

While the disclosure has been described with reference to particular embodiments, it will be readily apparent to those skilled in the art that it is possible to embody the invention in specific forms other than those of the embodiments described above. The described embodiments are merely illustrative and should not be considered restrictive in any way. Rather, the scope of the invention is given by the appended claims.

**Claims**

1. A method (400) of generating a radio frequency signal (302) based on a baseband signal (304), the method comprising:

   - providing (420) an amplitude signal (r; Vamp; $V_{ddm}$) and a phase signal ($\varphi$; [$I_p,Q_p$]) depending on the baseband signal (304);
   - modulating (430) the phase signal ($\varphi_o$; [$I_p,Q_p$]) to a carrier frequency ($\omega_c$) and amplifying the modulated phase signal according to the amplitude signal (r; Vamp; $V_{ddm}$) to generate a preliminary radio frequency signal (318) using a main modulating and amplifying unit (310); and
   - feeding (440) a peak compensation signal (321), which depends on the baseband signal (304), into the preliminary radio frequency signal (318) to generate the radio frequency signal (302), the peak compensation signal (321) being generated using an auxiliary modulating and amplifying unit (324) and configured to at least essentially compensate for a saturation in the main modulating and amplifying unit (310), wherein the auxiliary modulating and amplifying unit (324) is further used for feeding an offset compensation signal (320) into the preliminary radio frequency signal (318), when the baseband signal (304) is modified by adding an offset signal (314) to reduce a bandwidth expansion in at least one of the phase signal ($\varphi$; [$I_p,Q_p$]) and the amplitude signal (r; $V_{amp}$; $V_{ddm}$), the offset compensation signal (320) being derived from the offset signal (314).

2. The method of claim 1, wherein the peak compensation signal (321) increases as the amplitude signal (r) increases, if the baseband signal (304) is in at least one of a first signal region (806) and a second signal region (804), so that an amplitude of the radio frequency signal is a linear function of an amplitude of the baseband signal.

3. The method of claim 2, further comprising:

   - determining whether the baseband signal (304) is in the first signal region (806) or the second signal region (804), or predicting whether the baseband signal (304) enters into the first signal region (806) or the second signal region (804) based on the baseband signal (304) stored in a transmitter.

4. The method of claim 2 or 3, wherein at least the feeding of the peak compensation signal is subject to the condition that the baseband signal (304) is in the first signal region (804) or the second signal region (806).

5. The method of any one of claims 1 to 4, wherein the feeding of the peak compensation signal (321) into the preliminary radio frequency signal (318) further includes a calibrated combination of the peak compensation signal (321) and the preliminary radio frequency signal (318).

6. The method of claim 5, wherein the calibrated combination is based on one or more weight coefficients, the method further comprising:

   - statically or dynamically calibrating one or all of the weight coefficients so that a signal amplitude provided by each of the auxiliary modulating and amplifying unit and the main modulating and amplifying unit is a smooth function of time.

7. The method of any one of claims 2 to 6, wherein the peak compensation signal (321) is further configured to modify the preliminary radio frequency signal (318) so that the radio frequency signal (318) approaches a first output signal region corresponding to the first signal region (806) from a second output signal region corresponding to the second signal region (804) with a transition time of the radio frequency signal that is longer than a transition time of the preliminary radio frequency signal (318).

8. The method of any one of claims 1 to 7, further comprising:

   - determining or predicting whether the baseband signal (304) is in a fourth signal region (504) or enters into the fourth signal region (504).

9. The method of claim 8, further comprising, if the baseband signal is in the fourth signal region (504):

- modifying the baseband signal (304) by adding the offset signal to the baseband signal (304), the offset signal (314) being configured to prevent the modified baseband signal (316) from entering a fifth signal region (502); and
- feeding the offset compensation signal (320) derived from the offset signal (304) into the preliminary radio frequency signal (318) using the auxiliary modulating and amplifying unit (324), wherein the offset compensation signal (320) is configured to at least essentially cancel a distortion component, which corresponds to the offset signal (314).

10. The method of claim 8 or 9, wherein at least one of the fourth signal region (504) and the fifth signal region (502) changes depending on an output signal level of the radio frequency signal (302) and/or a modulation scheme applied for the baseband signal (304).

11. The method of any one of claims 8 to 10, wherein the offset compensation signal (320) and the peak compensation signal (321) are generated by an auxiliary power amplifier (324; 324-3), and wherein the phase signal ($\varphi$; [Ip,Qp]) is applied to the auxiliary power amplifier (324; 324-3) in at least one of the first signal region (806) and the second signal region (804) for peak compensation, and a phase signal opposite to the offset signal (314) is applied to the auxiliary power amplifier (324; 324-3) in at least one of the fourth signal region (504) and the fifth signal region (502) for offset compensation.

12. The method of claim 11, wherein the auxiliary power amplifier (324; 324-3) is a polar-modulated auxiliary power amplifier (324-3) or a quadrature-modulated auxillary power amplifier (324).

13. The method of any one of claims 1 to 12, wherein at least one of the modulation and the amplification is performed by operating a component (310; 310-3) in a non-linear mode or in a switched mode.

14. The method of any one of claims 1 to 13, wherein the deriving of the peak compensation signal (321) includes aligning the peak compensation signal (321) relative to the preliminary radio frequency signal (318) according to an alignment setting (328).

15. The method of any one of claims 1 to 14, wherein the peak compensation signal, the offset compensation signal or another compensation signal, which is generated by the auxiliary modulating and amplifying unit, is configured to compensate a distortion in the preliminary radio frequency signal created by the main modulating and amplifying unit or in a main power amplifier path including or downstream of the main modulating and amplifying unit.

16. A device (300; 1000; 1100) for generating a radio frequency signal (302) based on a baseband signal (304), the device comprising:

- a providing unit (308) adapted to provide an amplitude signal (r; $V_{amp}$; $V_{ddm}$) and a phase signal ($\varphi$; [$I_p$,$Q_p$]) depending on the baseband signal (304);
- a main modulating and amplifying unit (310) adapted to modulate the phase signal ($\varphi_o$; [$I_p$,$Q_p$]) to a carrier frequency ($\omega_c$) and to amplify the modulated phase signal according to the amplitude signal (r; Vamp; $V_{ddm}$) to generate a preliminary radio frequency signal (318); and
- a feeding unit (312) adapted to feed a peak compensation signal (321), which depends on the baseband signal (304), into the preliminary radio frequency signal (318) to generate the radio frequency signal (302), wherein the feeding unit (312) includes an auxiliary modulating and amplifying unit (324) adapted to generate the peak compensation signal (321) configured to at least essentially compensate for a saturation in the main modulating and amplifying unit (310), wherein the feeding unit (312) is further adapted to feed an offset compensation signal (320) generated by the auxiliary modulating and amplifying unit (324) into the preliminary radio frequency signal (318), when the baseband signal (304) is modified by adding an offset signal (314) to reduce a bandwidth expansion in at least one of the phase signal ($\varphi$; [$I_p$,$Q_p$]) and the amplitude signal (r; $V_{amp}$; $V_{ddm}$), the offset compensation signal (320) being derived from the offset signal (314).

**Patentansprüche**

1. Verfahren (400) zum Erzeugen eines Funkfrequenzsignals (302) auf der Grundlage eines Basisbandsignals (304), wobei das Verfahren umfasst:

- Bereitstellen (420) eines Amplitudensignals (R; $V_{amp}$; $V_{dm}$) und eines Phasensignals ($\varphi$; [$I_p$, $Q_P$]) abhängig

von dem Basisbandsignal (304);

- Modulieren (430) des Phasensignals ($\varphi_0$; [$I_p$, $Q_P$]) auf eine Trägerfrequenz ($\omega_c$) und Verstärken des modulierten Phasensignals gemäß dem Amplitudensignal (R; $V_{amp}$; $V_{dm}$), um ein Vorabfunkfrequenzsignal (318) unter Verwendung einer Hauptmodulations- und Verstärkungseinheit (310) zu erzeugen; und

- Zuführen (440) eines Spitzenkompensierungssignals (321), das von dem Basisbandsignal (304) abhängt, in das Vorabfunkfrequenzsignal (318), um das Funkfrequenzsignal (302) zu erzeugen, wobei das Spitzenkompensierungssignal (321) unter Verwendung einer Hilfsmodulations- und Verstärkungseinheit (342) erzeugt wird und konfiguriert ist, um zumindest im Wesentlichen eine Sättigung in der Hauptmodulations- und Verstärkungseinheit (310) zu kompensieren, wobei die Hilfsmodulations- und Verstärkungseinheit (324) weiterhin verwendet wird, um ein Offset-Kompensierungssignal (320) in das Vorabfunkfrequenzsignal (318) zuzuführen, wenn das Basisbandsignal (304) durch Addieren eines Offsetsignals (314) modifiziert wird, um eine Bandbreitenerweiterung in zumindest einem des Phasensignals ($\varphi$; [$I_p$, $Q_P$]) und des Amplitudensignals (R; $V_{amp}$; $V_{dm}$) zu verringern, wobei das Offset-Kompensierungssignal (320) aus dem Offsetsignal (314) hergeleitet wird.

2. Verfahren gemäß Anspruch 1, wobei das Spitzenkompensierungssignal (321) sich erhöht, wenn sich das Amplitudensignal (r) erhöht, falls das Basisbandsignal (304) sich in zumindest einem eines ersten Signalbereichs (806) und eines zweiten Signalbereichs (804) befindet, so dass eine Amplitude des Funkfrequenzsignals eine lineare Funktion einer Amplitude des Basisbandsignals ist.

3. Verfahren gemäß Anspruch 2, weiterhin umfassend:

- Bestimmen, ob das Basisbandsignal (304) sich in dem ersten Signalbereich (806) oder dem zweiten Signalbereich (804) befindet, oder Vorhersagen, ob das Basisbandsignal (304) in den ersten Signalbereich (806) oder den zweiten Signalbereich (804) eintritt, auf der Grundlage des Basisbandsignals (304), das in einem Sender gespeichert ist.

4. Verfahren gemäß Anspruch 2 oder 3, wobei zumindest das Zuführen des Spitzenkompensierungssignals der Bedingung unterworfen ist, dass sich das Basisbandsignal (304) in dem ersten Signalbereich (804) oder dem zweiten Signalbereich (806) befindet.

5. Verfahren gemäß zumindest einem der Ansprüche 1 bis 4, wobei das Zuführen des Spitzenkompensierungssignals (321) in das Vorabfunkfrequenzsignal (318) weiterhin eine kalibrierte Kombination des Spitzenkompensierungssignals (321) und des Vorabfunkfrequenzsignals (318) umfasst.

6. Verfahren gemäß Anspruch 5, wobei die kalibrierte Kombination auf einem oder mehreren Gewichtskoeffizienten basiert, wobei das Verfahren weiterhin umfasst:

- statistisches oder dynamisches Kalibrieren von einem oder allen Gewichtskoeffizienten derart, dass eine Signalamplitude, die durch jede der Hilfsmodulations- und Verstärkungseinheit und der Hauptmodulations- und Verstärkungseinheit bereitgestellt wird, eine glatte Funktion der Zeit ist.

7. Verfahren gemäß zumindest einem der Ansprüche 2 bis 6, wobei das Spitzenkompensierungssignal (321) weiterhin konfiguriert ist, um das Vorabfunkfrequenzsignal (318) derart zu modifizieren, das sich das Funkfrequenzsignal (318) einem ersten Ausgabesignalbereich entsprechend dem ersten Signalbereich (806) aus einem zweiten Ausgabesignalbereich entsprechend dem zweiten Signalbereich (804) mit einer Übergangszeit des Funkfrequenzsignals annähert, die länger als eine Übergangszeit des Vorabfunkfrequenzsignals (318) ist.

8. Verfahren gemäß zumindest einem der Ansprüche 1 bis 7, weiterhin umfassend:

- Bestimmen oder Vorhersagen, ob das Basisbandsignal (304) sich in einem vierten Signalbereich (504) befindet oder in den vierten Signalbereich (504) eintritt.

9. Verfahren gemäß Anspruch 8, weiterhin umfassend, falls sich das Basisbandsignal in den vierten Signalbereich (504) befindet:

- Modifizieren des Basisbandsignals (304) durch Addieren des Offsetsignals (314) zu dem Basisbandsignal (304), wobei das Offsetsignal (314) konfiguriert ist, um das modifizierte Basisbandsignal (316) daran zu hindern, in einen fünften Signalbereich (502) einzutreten; und

- Zuführen eines Offset-Kompensierungssignals (320), das aus dem Offsetsignal (304) hergeleitet ist, in das Vorabfunkfrequenzsignal (318) unter Verwendung der Hilfsmodulations- und Verstärkungseinheit (324), wobei das Offset-Kompensierungssignal (320) konfiguriert ist, um zumindest im Wesentlichen eine Verzerrungskomponente zu beseitigen, die dem Offsetsignal (314) entspricht.

10. Verfahren gemäß Anspruch 8 oder 9, wobei zumindest einer des vierten Signalbereichs (504) und des fünften Signalbereichs (502) sich abhängig von einem Ausgabesignalpegel des Funkfrequenzsignals (320) und/oder einem für das Basisbandsignal (304) angewendeten Modulationsschema verändert.

11. Verfahren gemäß zumindest einem der Ansprüche 8 bis 10, wobei das Offset-Kompensierungssignal (320) und das Spitzenkompensierungssignal (321) durch einen Hilfeleistungsverstärker (324; 324-3) erzeugt werden, und wobei das Phasensignal ($\varphi$; [$I_p$, $Q_P$]) auf den Hilfsleistungsverstärker (324; 324-3) in zumindest einem des ersten Signalbereichs (806) und des zweiten Signalbereichs (804) für die Spitzenkompensierung angewendet wird, und ein Phasensignal, das dem Offsetsignal (314) entgegen gerichtet ist, bei dem Hilfsleistungsverstärker (324; 324-3) in zumindest einem des vierten Signalbereichs (504) und des fünften Signalbereichs (502) für die Offset-Kompensierung angewendet wird.

12. Verfahren gemäß Anspruch 11, wobei der Hilfsleistungsverstärker (324; 324-3) ein polarmodulierter Hilfsleistungsverstärker (324-3) oder eine quadraturmodulierter Hilfsleistungsverstärker (324) ist.

13. Verfahren gemäß zumindest einem der Ansprüche 1 bis 12, wobei zumindest eine der Modulation und der Verstärkung durchgeführt wird, indem eine Komponente (310; 310-3) in einem nicht-linearen Modus oder in einem geschalteten Modus operiert.

14. Verfahren gemäß zumindest einem der Ansprüche 1 bis 13, wobei das Herleiten des Spitzenkompensierungssignals (321) ein Ausrichten des Spitzenkompensierungssignals (321) relativ zu dem Vorabfunkfrequenzsignal (318) gemäß einer Ausrichtungseinstellung (328) umfasst.

15. Verfahren gemäß zumindest einem der Ansprüche 1 bis 14, wobei das Spitzenkompensierungssignal, das Offset-Kompensierungssignal oder ein weiteres Kompensierungssignal, das durch die Hilfsmodulations-Verstärkungseinheit erzeugt ist, konfiguriert ist, um eine Verzerrung in dem Vorabfunkfrequenzsignal zu kompensieren, die durch die Hauptmodulations- und Verstärkungseinheit oder in einem Hauptleistungsverstärkerpfad einschließlich oder stromabwärts der Hauptmodulations- und Verstärkungseinheit erstellt ist.

16. Vorrichtung (300; 1000; 1100) zum Erzeugen eines Funkfrequenzsignals (302) auf der Grundlage eines Basisbandsignals (304), wobei die Vorrichtung umfasst:

- eine Bereitstellungseinheit (308), die eingerichtet ist, um ein Amplitudensignal (R; $V_{AMP}$; $V_{DM}$) und ein Phasensignal ($\varphi$; [$I_p$, $Q_P$]) abhängig von dem Basisbandsignal (304) bereitzustellen;
- eine Hauptmodulations- und Verstärkungseinheit (310), die eingerichtet ist, um das Phasensignal ($\varphi_0$; [$I_p$, $Q_P$]) auf eine Trägerfrequenz ($\omega_c$) zu modulieren und das modulierte Phasensignal gemäß dem Amplitudensignal (R; $V_{AMP}$; $V_{DM}$) zu verstärken, um ein Vorabfunkfrequenzsignal (318) zu erzeugen; und
- eine Zuführungseinheit (312), die eingerichtet ist, um ein Spitzenkompensierungssignal (321), das von dem Basisbandsignal (304) anhängt, in das Vorabfunkfrequenzsignal (318) zuzuführen, um das Funkfrequenzsignal (302) zu erzeugen, wobei die Zuführungseinheit (312) eine Hilfsmodulations- und Verstärkungseinheit (324) umfasst, die eingerichtet ist, um das Spitzenkompensierungssignal (321), das konfiguriert ist, um zumindest im Wesentlichen eine Sättigung in der Hauptmodulations- und Verstärkungseinheit (310) zu kompensieren, zu erzeugen, wobei die Zuführungseinheit (312) weiterhin eingerichtet ist, um ein Offset-Kompensierungssignal (320), das durch die Hilfsmodulations- und Verstärkungseinheit (324) erzeugt ist, in das Vorabfunkfrequenzsignal (318) zuzuführen, wenn das Basisbandsignal (304) durch Addieren eines Offsetsignals (314) modifiziert wird, um eine Bandbreitenerweiterung in zumindest einem des Phasensignals ($\varphi$; [$I_p$, $Q_P$]) und des Amplitudensignals (R; $V_{AMP}$; $V_{DM}$) zu verringern, wobei das Offset-Kompensierungssignal (320) aus dem Offsetsignal (314) hergeleitet wird.

**Revendications**

1. Procédé (400) consistant à générer un signal de fréquence radio (302) sur la base d'un signal de bande de base (304), le procédé comprenant les étapes consistant à :

- délivrer (420) un signal d'amplitude (r ; Vamp ; $V_{ddm}$) et un signal de phase ($\varphi$ ; [$I_p$,$Q_p$]) en fonction du signal de bande de base (304) ;
- moduler (430) le signal de phase ($\varphi$ ; [$I_p$,$Q_p$]) sur une fréquence porteuse ($\omega_c$) et amplifier le signal de phase modulé conformément au signal d'amplitude (r ; $V_{amp}$ ; Vddm) pour générer un signal de fréquence radio préliminaire (318) en utilisant une unité de modulation et d'amplification principale (310) ; et
- délivrer (440) un signal de compensation de crête (321), qui dépend du signal de bande de base (304), dans le signal de fréquence radio préliminaire (318) pour générer le signal de fréquence radio (302), le signal de compensation de crête (321) étant généré en utilisant une unité de modulation et d'amplification auxiliaire (324) et configuré pour au moins essentiellement compenser une saturation dans l'unité de modulation et d'amplification principale (310), dans lequel l'unité de modulation et d'amplification auxiliaire (324) est en outre utilisée pour délivrer un signal de compensation de décalage (320) dans le signal de fréquence radio préliminaire (318), lorsque le signal de bande de base (304) est modifié par ajouter un signal de décalage (314) pour réduire une augmentation de la largeur de bande dans au moins l'un parmi le signal de phase ($\varphi$ ; [$I_p$,$Q_p$]) et le signal d'amplitude (r ; $V_{amp}$ ; $V_{ddm}$), le signal de compensation de décalage (320) étant dérivé du signal de décalage (314).

2.  Procédé selon la revendication 1, dans lequel le signal de compensation de crête (321) augmente à mesure que le signal d'amplitude (r) augmente, si le signal de bande de base (304) se trouve dans au moins l'une parmi une première région de signal (806) et une deuxième région de signal (804), de sorte qu'une amplitude du signal de fréquence radio est une fonction linéaire d'une amplitude du signal de bande de base.

3.  Procédé selon la revendication 2, comprenant en outre les étapes consistant à :

    - déterminer si le signal de bande de base (304) se trouve dans la première région de signal (806) ou la deuxième région de signal (804), ou prédire si le signal de bande de base (304) entre dans la première région de signal (806) ou la deuxième région de signal (804) sur la base du signal de bande de base (304) mémorisé dans un émetteur.

4.  Procédé selon la revendication 2 ou 3, dans lequel au moins la délivrance du signal de compensation de crête est soumise à la condition que le signal de bande de base (304) se trouve dans la première région de signal (804) ou la deuxième région de signal (806).

5.  Procédé selon l'une quelconque des revendications 1 à 4, dans lequel la délivrance du signal de compensation de crête (321) dans le signal de fréquence radio préliminaire (318) comprend en outre une combinaison calibrée du signal de compensation de crête (321) et du signal de fréquence radio préliminaire (318).

6.  Procédé selon la revendication 5, dans lequel la combinaison calibrée est basée sur un ou plusieurs coefficients de pondération, le procédé comprenant en outre l'étape consistant à :

    - calibrer de manière statique ou dynamique l'un ou la totalité des coefficients de pondération de sorte qu'une amplitude de signal délivré par chacune parmi l'unité de modulation et d'amplification auxiliaire et l'unité de modulation et d'amplification principale est une fonction de lissage du temps.

7.  Procédé selon l'une quelconque des revendications 2 à 6, dans lequel le signal de compensation de crête (321) est en outre configuré pour modifier le signal de fréquence radio préliminaire (318) de sorte que le signal de fréquence radio (318) approche une première région de signal de sortie correspondant à la première région de signal (806) depuis une deuxième région de signal de sortie correspondant à la deuxième région de signal (804) avec un temps de transition du signal de fréquence radio qui est plus long qu'un temps de transition du signal de fréquence radio préliminaire (318).

8.  Procédé selon l'une quelconque des revendications 1 à 7, comprenant en outre l'étape consistant à :

    - déterminer ou prédire si le signal de bande de base (304) se situe dans une quatrième région de signal (504) ou entre dans la quatrième région de signal (504).

9.  Procédé selon la revendication 8, comprenant en outre, si le signal de bande de base se trouve dans la quatrième région de signal (504), les étapes consistant à :

- modifier le signal de bande de base (304) en ajoutant le signal de décalage (314) au signal de bande de base (304), le signal de décalage (314) étant configuré pour empêcher le signal de bande de base modifié (316) d'entrer dans une cinquième région de signal (502) ; et
- délivrer un signal de compensation de décalage (320) dérivé du signal de décalage (304) dans le signal de fréquence radio préliminaire (318) en utilisant l'unité de modulation et d'amplification auxiliaire (324), dans lequel le signal de compensation de décalage (320) est configuré pour au moins essentiellement annuler une composante de distorsion, qui correspond au signal de décalage (314).

10. Procédé selon la revendication 8 ou 9, dans lequel au moins l'une parmi la quatrième région de signal (504) et la cinquième région de signal (502) change en fonction d'un niveau de signal de sortie du signal de fréquence radio (302) et/ou d'un schéma de modulation appliqué pour le signal de bande de base (304).

11. Procédé selon l'une quelconque des revendications 8 à 10, dans lequel le signal de compensation de décalage (320) et le signal de compensation de crête (321) sont générés par un amplificateur de puissance auxiliaire (324 ; 324-3), et dans lequel le signal de phase ($\varphi$ ; [$I_p$,$Q_p$]) est appliqué à un amplificateur de puissance auxiliaire (324 ; 324-3) dans au moins l'une parmi la première région de signal (806) et la deuxième région de signal (804) pour compensation de crête, et un signal de phase opposé au signal de décalage (314) est appliqué à l'amplificateur de puissance auxiliaire (324 ; 324-3) dans au moins l'une parmi la quatrième région de signal (504) et la cinquième région de signal (502) pour compensation de décalage.

12. Procédé selon la revendication 11, dans lequel l'amplificateur de puissance auxiliaire (324 ; 324-3) est un amplificateur de puissance auxiliaire à modulation polaire (324-3) ou un amplificateur de puissance auxiliaire modulé en quadrature (324).

13. Procédé selon l'une quelconque des revendications 1 à 12, dans lequel au moins l'une parmi la modulation et l'amplification est exécutée en commandant un composant (310 ; 310-3) dans un mode non linéaire ou dans un mode commuté.

14. Procédé selon l'une quelconque des revendications 1 à 13, dans lequel la dérive du signal de compensation de crête (321) comprend l'alignement du signal de compensation de crête (321) par rapport au signal de fréquence radio préliminaire (318) conformément à un réglage d'alignement (328).

15. Procédé selon l'une quelconque des revendications 1 à 14, dans lequel le signal de compensation de crête, le signal de compensation de décalage ou un autre signal de compensation, qui est généré par l'unité de modulation et d'amplification auxiliaire, est configuré pour compenser une distorsion dans le signal de fréquence radio préliminaire créé par l'unité de modulation et d'amplification principale ou dans un trajet d'amplificateur de puissance principal comprenant l'unité de modulation et d'amplification principale ou en aval de celle-ci.

16. Dispositif (300 ; 1000 ; 1100) destiné à générer un signal de fréquence radio (302) sur la base d'un signal de bande de base (304), le dispositif comprenant :

- une unité d'alimentation (308) adaptée pour délivrer un signal d'amplitude (r ; Vamp ; $V_{ddm}$) et un signal de phase ($\varphi$ ; [$I_p$,$Q_p$]) en fonction du signal de bande de base (304) ;
- une unité de modulation et d'amplification principale (310) adaptée pour moduler le signal de phase ($\varphi$ ; [$I_p$,$Q_p$]) sur une fréquence porteuse ($\omega_c$) et pour amplifier le signal de phase modulé conformément au signal d'amplitude (r ; $V_{amp}$ ; $V_{ddm}$) pour générer un signal de fréquence radio préliminaire (318) ; et
- une unité d'alimentation (312) adaptée pour délivrer un signal de compensation de crête (321), qui dépend du signal de bande de base (304), dans le signal de fréquence radio préliminaire (318) pour générer le signal de fréquence radio (302), dans lequel l'unité d'alimentation (312) comprend une unité de modulation et d'amplification auxiliaire (324) adaptée pour générer le signal de compensation de crête (321) configuré pour au moins essentiellement compenser une saturation dans l'unité de modulation et d'amplification principale (310), dans lequel l'unité d'alimentation (312) est en outre adaptée pour délivrer un signal de compensation de décalage (320) généré par l'unité de modulation et d'amplification auxiliaire (324) dans le signal de fréquence radio préliminaire (318), lorsque le signal de bande de base (304) est modifié par ajouter un signal de décalage (314) pour réduire une augmentation de la largeur de bande dans au moins l'un parmi le signal de phase ($\varphi$ ; [$I_p$,$Q_p$]) et le signal d'amplitude (r ; Vamp ; $V_{ddm}$), le signal de compensation de décalage (320) étant dérivé du signal de décalage (314).

Fig. 1

(a)  C1  C2  C3  C4  C5

(b)

(c)

(d)

EP 2 685 689 B1

Fig. 2

(a) Amplitude and IQ signals

(b) Phase

(c) Normalized I and Q signal

(d) Complex IQ

Fig. 3

400

```
┌─────────────────────────────────────────────────┐
│  Optionally modify a baseband signal by adding an │
│  offset signal to the baseband signal, the offset signal │
│  being configured to prevent the modified baseband │
│  signal from entering a fifth signal region        │──── 410
└─────────────────────────────────────────────────┘
                          │
                          ▼
┌─────────────────────────────────────────────────┐
│  Provide an amplitude signal (r; Vamp; Vddm) and a │
│  phase signal (φ; [Ip,Qp]) based on the original (or │
│  optionally modified) baseband signal               │──── 420
└─────────────────────────────────────────────────┘
                          │
                          ▼
┌─────────────────────────────────────────────────┐
│  Modulate the phase signal (φ; [Ip,Qp]) to a carrier │
│  frequency ($\omega_c$) and amplify the modulated phase signal │
│  according to the amplitude signal (r; Vamp; Vddm) to │
│  generate a preliminary radio frequency signal using a │
│  main modulating and amplifying unit              │──── 430
└─────────────────────────────────────────────────┘
                          │
                          ▼
┌─────────────────────────────────────────────────┐
│  Feed a peak compensation signal, which depends on │
│  the baseband signal, into the preliminary radio   │
│  frequency signal to generate the radio frequency signal, │
│  the peak compensation signal being generated using │
│  an auxiliary modulating and amplifying unit and   │
│  configured to at least essentially compensate for a │
│  saturation in the main modulating and amplifying unit, │──── 440
│  wherein the auxiliary modulating and amplifying unit is │
│  further used for feeding an offset compensation signal │
│  into the preliminary radio frequency signal, when the │
│  baseband signal is modified to reduce a bandwidth │
│  expansion in at least one of the phase signal (φ; [$I_p,Q_p$]) │
│  and the amplitude signal (r; $V_{amp}$; $V_{ddm}$) │
└─────────────────────────────────────────────────┘
```

# Fig. 4

Fig. 5

(a)          (b)          (c)

Fig. 6

Fig. 7

Fig. 8

Fig. 9

Fig. 10

Fig. 11

324-3

outp

$D_{(1)}$ $D_{(2)}$ $D_{(n-1)}$ $D_{(n)}$

$\cos(\omega_c t + \beta)$

## Fig. 12a

324-3

outn

$D_{(1)}$ $D_{(2)}$ $D_{(n-1)}$ $D_{(n)}$

$\cos(\omega_c t + \beta + 180°)$

## Fig. 12b

Fig. 13

**EP 2 685 689 B1**

**Patent documents cited in the description**

- US 20020122467 A